# EUROPEAN PATENT APPLICATION

(11) **EP 2 549 546 A1**
(43) Date of publication of application: **23.01.2013**
(21) Application number: 11756355.1
(22) Date of filing: 16.03.2011
(51) Int. Cl.: H01L 31/04

(54) **LIGHT-ABSORBING MATERIAL AND PHOTOELECTRIC CONVERSION ELEMENT USING SAME**

(30) Priority: 18.03.2010 JP 2010062901; 18.03.2010 JP 2010062895
(71) Applicant: National University Corporation Kyoto Institute of Technology, Sakyo-ku Kyoto-shi, Kyoto 606-8585 (JP)
(72) Inventor: SONODA, Saki, Kyoto-shi Kyoto 606-8585 (JP); KATO, Junichi, Kyoto-shi Kyoto 606-8585 (JP); KAWASAKI, Osamu, Kyoto-shi Kyoto 606-8585 (JP); TAKENAGA, Mutsuo, Kyoto-shi Kyoto 606-8585 (JP)
(74) Representative: HOFFMANN EITLE
(86) International application number: PCT/JP2011/056211
(87) International publication number: WO 2011/115171

(57) **Abstract**

A new light-absorbing material which can increase the conversion efficiency of a solar cell and a photoelectric conversion element using same are provided. The light-absorbing material of the present invention comprises a nitride-based compound semiconductor obtained by replacement of part of Al and/or Ga in a compound semiconductor expressed by a general formula Al_{1-y}Ga_{y}N (0≤y≤1) by at least one kind of 3d-transition metals, the nitride-based compound semiconductor having one or more impurity bands between a valence band and a conduction band, and whose light absorption coefficient over an overall wavelength region of not longer than 1500 nm and not shorter than 300 being not lower than 1000 cm⁻¹.

## Description

### Technical Field

The present invention relates to a light-absorbing material having a multiband structure, and a photoelectric conversion element using the same.

### Background Art

In recent years, against the backdrop of a global environmental problem such as a CO₂ emission problem, an energy cost problem such as a rise in crude oil price, and the like, there is an increasing expectation toward a solar cell using sunlight which is clean and inexhaustible. A solar cell chiefly used at present is a unijunction solar cell made up of one pn-junction element using monocrystal silicon or polycrystal silicon as a semiconductor. Theoretical conversion efficiency (percentage of convertibility of incident energy to electric energy) of this unijunction solar cell is said to be on the order of 28%, but on a practical level, for example in the case of the monocrystal silicon solar cell, the efficiency is typically from 15% to 17%.

The semiconductor such as silicon which is used for the solar cell has a specific band gap, and when the semiconductor absorbs optical energy corresponding to the band gap, electrons in a valence band are excited to a conduction band, while holes are generated in the valence band, and these electrons and holes are accelerated by an internal field formed by pn-junction and flow as a current to the outside, thereby generating an electromotive force. At that time, light with lower energy than the band gap transmits through the semiconductor without being absorbed (transmission loss). Further, although light with higher energy than the band gap is absorbed, most of the energy is wasted as heat (heat energy loss). Accordingly, if light in an unused wavelength region of sunlight can be utilized, the conversion efficiency of the solar cell can be significantly improved.

As methods for utilizing light in the unused wavelength region, there have been proposed a method of using a multijunction solar cell formed by lamination of a plurality of pn-junction elements having different band gaps, such as a solar cell with a tandem structure (e.g. Nonpatent Document 1), and a method of using a unijunction solar cell using a multiband structure where an intermediate band such as an impurity band is introduced into a band gap of a semiconductor and absorbs long-wavelength light, which is normally not absorbable, through use of the intermediate band (e.g. Patent Document 1, Nonpatent Document 2).

In the case of using the multijunction solar cell, a plurality of elements are laminated sequentially from the light incident side so as to make the band gap smaller, and shorter-wavelength light is used to generate electric power in the incident-side element while longer-wavelength light is used to generate electric power in the lower-layered element. This enables the use of light in a broad wavelength region of sunlight, thereby reducing the transmission loss due to long-wavelength light and the heat energy loss due to short-wavelength light. Theoretically, a conversion efficiency of not lower than 60% can be expected. However, with the solar cell basically having a structure in which the elements are vertically connected in series, there has been a problem in that a current amount of an entire battery decreases when the electric power generation efficiency deteriorates and a current decreases even in any one of the respective layers. For example, even if a solar cell with the tandem structure optimally designed based on ideal sunlight of AM-1.5 (sunlight spectrum on the earth's surface) is used, there is generally a little light with a wavelength in the vicinity of red on a cloudy day, and hence the electric power generation efficiency of an element targeting at light in the vicinity of red falls to an extremely low level. There has thus been a problem with the tandem type solar cell in that its ability can be sufficiently exerted only on a sunny day. There has further been a problem in that, although the multijunction type involves lamination of materials with different lattice constants, it is difficult to ensure lattice matching. For this reason, a three-junction type using compound semiconductors of GalnP/GaAs/InGaAs has only gained a conversion efficiency of about 33%.

On the other hand, in the unijunction solar cell using the multiband structure, high conversion efficiency can be expected since an electron-hole pair is generated both in light absorption in two or more stages through the intermediate band and in light absorption by means of a band gap of a base semiconductor. As examples of this there are, for example, proposed one using a Zn₁-_{y}Mn_{y}OₓTe₁₋ₓ alloy (Patent Document 1), and one using a quantum dot super lattice structure in an interlayer between a p-layer and an n-layer (Nonpatent Document 2). According to the method of Patent Document 1, it is confirmed that addition of oxygen to the ZnMnTe alloy leads to formation of a new intermediate band. This is said to allow enhancement of matching with a spectrum of sunlight, and thus theoretically allow expectation of a conversion efficiency of not lower than 50% even in the unijunction type. However, subsequently to ion-planting of oxygen, melting by use of a pulse laser is necessary, and a complicated manufacturing process has thus been a major problem. Meanwhile, in the method of Nonpatent Document 2, an absorption wavelength can be selected by controlling a size of a quantum dot, so as to expect enhancement in matching with the spectrum of sunlight, and further, with electron energy relaxation time being slower in the quantum dot than in a bulk crystal, the electrons may be extracted to the outside before occurrence of energy relaxation due to phonon emission. Moreover, it is said that with the superlattice structure formed, an intermediate band is formed by coupling between the quantum dots, which may allow absorption of light with a plurality of wavelengths. However, a conversion efficiency of only the order of 30% has been practically obtained.

On the other hand, as a light-absorbing material for heat utilization of sunlight, a material which is two-dimensionally arrayed and has a periodical surface fine uneven pattern is described in Patent Document 2, but this material is difficult to manufacture since formation of a regular uneven array is required.

As for a band structure of a compound obtained by replacement of part of Al or Ga in AIN or GaN by a 3d-transition metal element, which is concerned with the present invention, it is reported in a document that an energy level is formed between the valence band and the conduction band, and the energy level in a compound obtained by replacement of part of Al or Ga in AIN or GaN by a 3d-transition metal element Sc, Ti, V, Cr, Mn, Fe, Co, Ni or Cu is obtained by calculation (Nonpatent Document 3). However, the use of the compound as a photoelectric material is not proposed. Further, it is reported that in light absorption spectrums of GaN or AIN added with the order of 10²⁰/cm⁻³ (the order of 0.1%) of Mn, a light absorption peak exists at about 1.5 eV (Nonpatent Document 4). However, with an added amount of Mn being small, performance as the light-absorbing material is low, and for example, as for a light absorption coefficient in a wavelength region of 300 to 1500 nm with high sunlight radiation intensity which is important for obtaining high electric power generation efficiency as a photoelectric conversion element for sunlight electric power generation, only a minimum value on the order of 600 to 700 cm⁻¹ can be realized in GaN and a minimum value on the order of 200 to 300 cm⁻¹ can be realized in AIN. Further, replacement of a solid solution of GaN and AIN by the 3d-transition metal element is not described. In order to obtain high conversion efficiency in the solar cell, the light absorption coefficient in the wavelength region of 300 to 1500 nm is desired to be higher.

### Citation List

- Patent Document 1:Japanese Unexamined Patent Publication No. 2007-535129 (Translation of PCT Application)
- Patent Document 2:Japanese Unexamined Patent Publication No. 2003-332607
- Nonpatent Document 1:Phys. Rev. Lett., 91, 246403 (2003)
- Nonpatent Document 2:Phys. Rev. Lett., 78, 5014 (1997)
- Nonpatent Document 3:Phys. Rev. B 66, 041203 (2002)
- Nonpatent Document 4:Appl. Phys. Lett., 81 5159 (2002)

### Summary of Invention

### Technical Problem

As thus described, although the attempts have hitherto been made to use light in an unused wavelength region of sunlight so as to improve conversion efficiency of a solar cell, a practically usable technique has not been found under the present circumstances.

In view of the above respects, the inventors propose in Japanese patent Application No. 2009-038224 a GaN-based compound semiconductor obtained by replacement of part of Ga by at least one kind of 3d-transition metals as a light-absorbing material, and a photoelectric conversion element using this. In this invention, energy of not higher than 3.4 eV can be efficiently absorbed between a valence band and a conduction band of GaN as a compound semiconductor having a bandgap of about 3.4 eV by means of an impurity band generated by replacement of a 3d-transition metal, thus improving electric power generation efficiency more than that of a currently used Si-based solar cell.

Further, the use of high-energy-side light requires the use of a compound semiconductor having a wider band gap than GaN. GaN and AIN form a solid solution in an entire composition range, and its band gap increases from 3.4 to 6.2 eV of AIN with increase in amount of Al. Moreover, since an open-end voltage of a solar cell depends on a size of the band gap and a higher voltage can be generally obtained with a wider band gap, a required output voltage can be obtained even when the number of elements of solar cell elements connected in series is reduced.

Accordingly, an object of the present invention is to provide a new light-absorbing material and a photoelectric conversion element using the same, which are capable of improving conversion efficiency of a solar cell, and further increasing an output voltage.

### Solution to Problem

The present inventors conducted dedicated studies for solving the above problems, and consequently found that, when part of Al and/or Ga in a compound semiconductor expressed by Al_{1-y}Ga_{y}N is replaced by at least one kind of 3d-transition metals, a light absorption coefficient in a wavelength region including ultraviolet rays to infrared rays, namely a wavelength region of not longer than 1500 nm and not shorter than 300 nm, is not smaller than 1000 cm⁻¹. Further, the present inventors found that the nitride-based compound semiconductor having an impurity band is easy to manufacture and deteriorates in an extremely small degree in a usage environment, and the present inventors produced a photoelectric conversion element using the above nitride-based compound semiconductor as a photoelectric conversion material. This leads to completion of a photoelectric conversion element with high efficiency and high reliability, which extracts electrons excited by irradiation of the nitride-based compound semiconductor with sunlight. It goes without saying that light with which the nitride-based compound semiconductor is irradiated is not restricted to sunlight.

That is, a light-absorbing material of the present invention, includes a nitride-based compound semiconductor obtained by replacement of part of Al and/or Ga in a compound semiconductor expressed by a general formula Al_{1-y}Ga_{y}N (0≤y≤1) by at least one kind of 3d-transition metals, the nitride-based compound semiconductor has one or more impurity bands between a valence band and a conduction band, and whose light absorption coefficient over an overall wavelength region of not longer than 1500 nm and not shorter than 300 nm is not lower than 1000 cm⁻¹.

For the light-absorbing material of the present invention, at least one selected from the group consisting of Sc, Ti, V, Cr, Mn, Fe, Co, Ni and Cu can be used as a 3d-transition metal.

For the light-absorbing material of the present invention, when Ga replacement amount with respect to Al above is y and a replacement amount of a 3d-transition metal T is x, one expressed by a general formula (Al₁-yGa_{y})₁₋ₓTₓN, where 0≤y≤g1.0, and 0.02≤x≤0.3, can also be used.

Further, for the light-absorbing material of the present invention, one obtained by doping with an acceptor dopant and/or a donor dopant can also be used as the nitride-based compound semiconductor.

Further, for the light-absorbing material of the present invention, a compound semiconductor, where y in the above general formula is 0≤y<1, can also be used.

A photoelectric conversion element of the present invention is one using the light-absorbing material of the present invention as a photoelectric conversion material.

That is, a photoelectric conversion element of the present invention is a photoelectric conversion element obtained by formation of a photoelectric conversion layer made up of at least one pn-junction or pan-junction by a plurality of compound semiconductor layers, wherein at least one layer of the plurality of compound semiconductor layers is a nitride-based compound semiconductor layer being made up of a GaN-based, GaAlN-based or AlN-based compound semiconductor obtained by replacement of Ga and/or Al by at least one kind of 3d-transition metals and having at least one or more impurity bands between a valence band and a conduction band, and whose light absorption coefficient over an overall wavelength region of not longer than 1500 nm and not shorter than 300 nm is not lower than 1000 cm⁻¹.

For the photoelectric conversion element of the present invention, at least one selected from the group consisting of Sc, Ti, V, Cr, Mn, Fe, Co, Ni and Cu can be used as the 3d-transition metal T.

Further, in the photoelectric conversion element of the present invention, one obtained by doping with an acceptor dopant and/or a donor dopant can be used for the nitride-based compound semiconductor layer.

Further, in the photoelectric conversion element of the present invention, at least one selected from the group consisting of Mg, Ca and C can be used as the acceptor dopant, and at least one selected from the group consisting of hydrogen atoms, Si and oxygen atoms can be used as the donor dopant.

Further, in the photoelectric conversion element of the present invention, the nitride-based compound semiconductor layer may have a pair of opposed principal surfaces, and the element may have: an n-type conductive nitride-based compound semiconductor layer, which is formed in contact with one principal surface of the nitride-based compound semiconductor layer, and made up of an n-GaN-based, n-GaAIN-based or n-AlN-based compound semiconductor having n-type conductivity; a p-type conductive nitride-based compound semiconductor layer, which is formed in contact with the other principal surface of the nitride-based compound semiconductor layer, and made up of a p-GaN-based, p-GaAIN-based or p-AlN-based compound semiconductor having p-type conductivity; and at least one pair of electrodes formed respectively on the n-type conductive nitride-based compound semiconductor layer and the p-type conductive nitride-based compound semiconductor layer.

Further, the photoelectric conversion element of the present invention may have: a substrate; an n-type conductive nitride-based compound semiconductor layer, which is formed on the substrate, and made up of an n-GaN-based, n-GaAIN-based or n-AlN-based compound semiconductor having n-type conductivity; the nitride-based compound semiconductor layer formed on the n-type conductive nitride-based compound semiconductor layer; a p-type conductive nitride-based compound semiconductor layer, which is formed in contact with the nitride-based compound semiconductor layer, and made up of a p-GaN-based, p-GaAlN-based or p-AIN-based compound semiconductor having p-type conductivity; and at least one pair of electrodes formed respectively on the n-type conductive nitride-based compound semiconductor layer and the p-type conductive nitride-based compound semiconductor layer.

Further, the photoelectric conversion element of the present invention may have: a substrate; a p-type conductive nitride-based compound semiconductor layer, which is formed on the substrate, and made up of a p-GaN-based, p-GaAlN-based or p-AIN-based compound semiconductor having p-type conductivity; the nitride-based compound semiconductor layer formed on the p-type conductive nitride-based compound semiconductor layer; an n-type conductive nitride-based compound semiconductor layer, which is formed in contact with the nitride-based compound semiconductor layer, and made up of an n-GaN-based, n-GaAlN-based or n-AlN-based compound semiconductor having n-type conductivity; and at least one pair of electrodes formed respectively on the p-type conductive nitride-based compound semiconductor layer and the n-type conductive nitride-based compound semiconductor layer.

Further, the photoelectric conversion element of the present invention may have: the nitride-based compound semiconductor layer; an n-type conductive nitride-based compound semiconductor layer, which is formed in contact with the nitride-based compound semiconductor layer, and made up of an n-GaN-based, n-GaAIN-based or n-AlN-based compound semiconductor having n-type conductivity; and at least one pair of electrodes formed respectively on the nitride-based compound semiconductor layer and the n-type conductive nitride-based compound semiconductor layer.

Further, the photoelectric conversion element of the present invention may have: a substrate; an n-type conductive nitride-based compound semiconductor layer, which is formed on the substrate, and made up of an n-GaN-based, n-GaAlN-based or n-AlN-based compound semiconductor having n-type conductivity; the nitride-based compound semiconductor layer formed on the n-type conductive nitride-based compound semiconductor layer; and at least one pair of electrodes formed respectively on the n-type conductive nitride-based compound semiconductor layer and the nitride-based compound semiconductor layer.

Further, the photoelectric conversion element of the present invention may have: a substrate; the nitride-based compound semiconductor layer formed on the substrate; an n-type conductive nitride-based compound semiconductor layer, which is formed in contact with the nitride-based compound semiconductor layer, and made up of an n-GaN-based, n-GaAIN-based or n-AlN-based compound semiconductor having n-type conductivity; and at least one pair of electrodes formed respectively on the nitride-based compound semiconductor layer and the n-type conductive nitride-based compound semiconductor layer.

Further, the photoelectric conversion element of the present invention may have: the nitride-based compound semiconductor layer; a p-type conductive nitride-based compound semiconductor layer, which is formed in contact with the nitride-based compound semiconductor layer, and made up of a p-GaN-based, p-GaAlN-based or p-AlN-based compound semiconductor having p-type conductivity; and at least one pair of electrodes formed respectively on the nitride-based compound semiconductor layer and the p-type conductive nitride-based compound semiconductor layer.

Further, the photoelectric conversion element of the present invention may have: a substrate; a p-type conductive nitride-based compound semiconductor layer, which is formed on the substrate, and made up of a p-GaN-based, p-GaAlN-based or p-AIN-based compound semiconductor having p-type conductivity; the nitride-based compound semiconductor layer formed on the p-type conductive nitride-based compound semiconductor layer; and at least one pair of electrodes formed respectively on the nitride-based compound semiconductor layer and the p-type conductive nitride-based compound semiconductor layer.

Further, the photoelectric conversion element of the present invention may have: a substrate; the nitride-based compound semiconductor layer formed on the substrate; a p-type conductive nitride-based compound semiconductor layer, which is formed in contact with the nitride-based compound semiconductor layer, and made up of a p-GaN-based, p-GaAlN-based or p-AIN-based compound semiconductor having p-type conductivity; and at least one pair of electrodes formed respectively on the nitride-based compound semiconductor layer and the p-type conductive nitride-based compound semiconductor layer.

### Advantageous Effects of Invention

The nitride-based compound semiconductor as the light-absorbing material of the present invention has the impurity band in the bang gap in GaN or the band gap in the solid solution made up of AIN and GaN, or the band gap in AIN, and hence the semiconductor can absorb light in the visible light region, and further light in the infrared ray region, which are unabsorbable in the conventional nitride-based compound semiconductor having no impurity band. That is, light from the ultraviolet region of not shorter than 300 nm to the infrared region of not longer than 1500 nm can be absorbed with high efficiency of not smaller than 1000 cm⁻¹. Furthermore, a light absorption coefficient indicates a large value of not smaller than 3000 cm⁻¹ in a wavelength region of 300 to 1100 nm. That is, excitation is generated from the valence band to the conduction band by excitation through the impurity band, to allow utilization of sunlight with a wavelength which has been not usable in the conventional nitride-based compound semiconductor, thereby improving the conversion efficiency.

Further, since the nitride-based compound semiconductor as the light-absorbing material of the present invention is excellent in heat resistance, mechanically robust and chemically stable, even in a severe environment of outdoor installation and light-collecting operation where a temperature increases with sunlight, it is possible to realize a photoelectric conversion element with a small dark current value, extremely small deterioration and high reliability.

Moreover, since the nitride-based compound semiconductor as the light-absorbing material of the present invention does not use a highly toxic element such as As or Cd, as in a GaAs-based or CdTe-based compound semiconductor, it is also environmentally excellent. Furthermore, since no rare metal is used or an extremely small amount of rare metal is used, a lower-cost photoelectric conversion can be provided.

Further, since the nitride-based compound semiconductor as the light-absorbing material of the present invention can absorb sunlight in a broad wavelength region, it is also useful for heat utilization of sunlight, and as a material for a light-absorbing element such as an optical filter for absorbing light in a broad range of the wavelength region.

Moreover, the photoelectric conversion element of the present invention has an extremely simple structure and can further be manufactured not only by a MBE method but by a film forming method such as sputtering with an extremely small number of manufacturing processes as compared with one obtained by using a Zn_{1-y}Mn_{y}OₓTe₁₋ₓ alloy, and furthermore facilitates mass manufacturing as compared with one using a quantum dot, so as to provide a lower-cost photoelectric conversion element.

### Brief Description of Drawings

FIG. 1 is a schematic view showing a band structure of GaMnN as one example of a light-absorbing material of the present invention.
FIG. 2 is a schematic view showing a structure of a first solar cell using GaMnN as a photoelectric conversion material in a photoelectric conversion element example 1.
FIG. 3 is a schematic view showing a band structure of the solar cell of FIG. 2.
FIG. 4 is a schematic view showing a structure of solar cells where a plurality of solar cells each having the structure of FIG. 2 are connected in series.
FIG. 5 is a schematic view showing another structural example of solar cells where a plurality of solar cells having the structure of FIG. 2 are connected in series.
FIG. 6 is a graph showing a voltage-current characteristic at the time of irradiating one solar cell shown in FIG. 2, 4 or 5 with sunlight.
FIG. 7 is graph showing a time variation characteristic of an open-end voltage at the time of irradiating one solar cell shown in FIG. 2, 4 or 5 with sunlight.
FIG. 8 is a graph showing a time variation characteristic of a short-circuit current at the time of irradiating one solar cell shown in FIG. 2, 4 or 5 with sunlight.
FIG. 9 is a schematic view showing a structure of a second solar cell using GaMnN as a photoelectric conversion material in a photoelectric conversion element example 2.
FIG. 10 is a schematic view showing a structure of a third solar cell using GaMnN as a photoelectric conversion material in a photoelectric conversion element example 3.
FIG. 11 is a schematic view showing a band structure of the solar cell having the structure of FIG. 10.
FIG. 12 is a graph showing a voltage-current characteristic at the time of irradiating with sunlight a solar cell having a pn structure using AlGaNiN as a photoelectric conversion material.
FIG. 13 is a schematic view showing a structure of solar cells where a plurality of solar cells each having the structure of FIG. 10 are connected in series.
FIG. 14 is a schematic view showing another structure of the solar cells where a plurality of solar cells each having the structure of FIG. 10 are connected in series.
FIG. 15 is a schematic view showing a structure of a fourth solar cell using GaMnN as a photoelectric conversion material in a photoelectric conversion element example 4.
FIG. 16 is a schematic view showing a structure of a fifth solar cell using GaMnN as a photoelectric conversion material in a photoelectric conversion element example 5.
FIG. 17 is a schematic view showing a band structure of the solar cell having the structure of FIG. 16.
FIG. 18 is a schematic view showing a structure of a sixth solar cell using GaMnN as a photoelectric conversion material in a photoelectric conversion element example 6.
FIG. 19 is a schematic view showing a constitutional example of a sputtering device used for producing the light-absorbing material of the present invention.
FIG. 20 is light absorption spectrums of GaVN, AlGaVN and AlVN obtained by replacement (5%) by V in Example 1.
FIG. 21 is light absorption spectrums of GaCrN, AlGaCrN and AlCrN obtained by replacement (9%) by Cr in Example 1.
FIG. 22 is light absorption spectrums of AlMnN (Mn: 11%) and AlGaMnN (Mn: 20%) in Example 1.
FIG. 23 is light absorption spectrums of GaCoN and AlCoN in Example 1.
FIG. 24 is light absorption spectrums of AlNiN and AlGaNiN obtained by replacement (10%) by Ni in Example 1.
FIG. 25 is a graph showing a radiant intensity spectrum (AM-1.5) of sunlight on the earth's surface.
FIG. 26 is a graph showing voltage-current characteristics at the time of irradiation and non-irradiation of a pn-type photoelectric conversion element, where (AlGa)NiN is film-formed on p-GaN, with optical energy of AM-1.5 in Example 2.
FIG. 27 is a light absorption spectrum of a light-absorbing material of Example 3.
FIG. 28 is a light absorption spectrum of a light-absorbing material of Example 6.
FIG. 29 is a light absorption spectrum of a light-absorbing material of Example 7, where a 3d-transition metal is V and x = 0.056.
FIG. 30 is a light absorption spectrum of a light-absorbing material of Example 7, where a 3d-transition metal is Cr and x = 0.088.
FIG. 31 is a light absorption spectrum of a light-absorbing material of Example 7, where a 3d-transition metal is Co, x = 0.052 and x = 0.128.
FIG. 32 is a light absorption spectrum of a light-absorbing material of Example 7, where a 3d-transition metal is Mn and x = 0.2.
FIG. 33 is a light absorption spectrum of a Ga₁₋ₓCrₓN film in Example 8.
FIG. 34 is a graph showing a voltage-current characteristic at the time of irradiating a solar cell having a pn structure of Example 9 with sunlight.
FIG. 35 is a graph showing a voltage-current characteristic at the time of irradiating a solar cell having a pan structure of Example 10 with sunlight.

### Description of Embodiments

Hereinafter, the present invention will be described in detail with reference to the drawings and the like.

### [Light-absorbing material]

A light-absorbing material of the present invention includes a nitride-based compound semiconductor obtained by replacement of part of Al and/or Ga in a compound semiconductor expressed by a general formula Al_{1-y}Ga_{y}N (0≤y≤1) by at least one kind of 3d-transition metals, characterized in that one or more impurity bands are provided between a valence band and a conduction band, and a light absorption coefficient in an overall wavelength region of not longer than 1500 nm and not shorter than 300 nm is not smaller than 1000 cm⁻¹. Preferably, y in the general formula A_{1-y}Ga_{y}N satisfies 0≤y<1.

A compound semiconductor expressed by a general formula (Al_{1-y}Gay)₁₋ₓTₓN (T denotes a 3d-transition metal) is a compound semiconductor having a composition formed by replacement of part of Al and/or Ga in the nitride-based compound semiconductor by at least one kind of 3d-transition metals. Since the nitride-based compound semiconductor is a semiconductor having a band gap of 3.4 to 6.2 eV (corresponding to a light wavelength of 200 to 365 nm) and not absorbing visible light, it does not generate a photocurrent even when irradiated with visible light. (Al_{1-y}Ga_{y})₁₋ₓ-Tₓ,N of the present invention can adjust the band gap by means of a Ga amount y in the range of 3.4 to 6.2 eV, and has an impurity band made up of the replaced 3d-transition metal in the band gap while being in the state of holding a band structure of the AlN-GaN solid solution. It is to be noted that in the present invention, replacing part of Al and/or Ga by the 3d-transition metal means being able to replace Al and/or Ga by the 3d-transition metal within a range where the replaced 3d-transition metal can form the impurity band.

For the 3d-transition metal, at least one or more kinds of metals, selected from the group consisting of Sc, Ti, V, Cr, Mn, Fe, Co, Ni and Cu, are preferably used. The band chiefly composed of a 3d-orbit of the transition metal can form the impurity band in the band gap of the AlN-GaN solid solution without being superimposed with the valence band and the conduction band. Herein, an element particularly preferable for formation of the impurity band as the 3d-transition metal is V, Cr, Mn, Co and Ni, and an intermediate band is formed in the forbidden gap. Further, even by use of two or more kinds of 3d-transition metals, the impurity bands corresponding to those kinds of metals can be formed, and hence two or more impurity bands can be formed. Herein, Sc, Ti, V, Cr, Mn, Fe, Co, Ni, and Cu respectively have electron arrangement of 3d 4s², 3d²4s², 3d³4s², 3d⁵4s, 3d⁵4s², 3d⁶4s², 3d⁷4s², 3d⁸4s² and 3d¹⁰4s. The 3d-transition metal has not more than two 4s-electrons in an outermost shell which form crystal bonds. Meanwhile, since one electron is short in replacement of trivalent Ga by the 3d-transition metal, one 3d-electron is used. This brings the impurity band capable of accommodating five d-electrons into an unoccupied state. When the impurity band comes into the unoccupied state, light can be absorbed in two or more stages through the impurity band, other than by direct transition from the valence band to the conduction band of the AlN-GaN solid solution, so that high conversion efficiency can be expected. In particular, V, Cr, Mn, Co and Ni is preferred for its high probability of carrier transition by irradiation with light since having good balance between the unoccupied state of the impurity band and a ground state of the electrons, as described above.

The nitride-based compound semiconductor containing the 3d-transition metal T can be expressed by the general formula (Al₁₋yGa_{y})₁₋ₓTₓN, where 0≤y≤1.0 and 0.02≤x≤0.3. The range of y is preferably 0≤y<1.0. The range of x is preferably 0.05≤x≤0.25, and more preferably 0.05≤x≤<0.20. When x is smaller than 0.02, an impurity band sufficient for being able to efficiently perform carrier transition by irradiation with light is not generated, and when x is larger than 0.3, the valence band and the impurity band are superimposed, and/or the conduction band and the impurity band are superimposed, and the impurity band is not formed therebetween. Herein, in the present invention, that an impurity band sufficient for being able to efficiently perform carrier transition by irradiation with light is not formed means that the light absorption coefficient in the wavelength region of 300 to 1500 nm is smaller than 1000 cm⁻¹.

Moreover, the light-absorbing material of the present invention is made up of a nitride-based compound semiconductor obtained by replacement of part of Al and/or Ga in the compound semiconductor expressed by a general formula Al_{1-y}Ga_{y}N by at least one kind of 3d-transition metals and by doping with an acceptor dopant and/or a donor dopant. A light absorption coefficient in a wavelength region of 300 to 1500 nm may be at least not smaller than 1000 cm⁻¹. Herein, the 3d-transition metals are metals with atomic numbers of 21 to 29, which are Sc, Ti, V, Cr, Mn, Fe, Co, Ni, and Cu. More preferable ones are V, Cr, Mn, Co and Ni.

The acceptor dopant normally receives electrons from a base material Al_{1-y}Ga_{y}N to generate holes in the valence band, but in the present invention, electrons are taken out of the impurity band derived from the 3d-orbit to allow formation of the unoccupied state in the impurity band. It is thereby possible to enhance the photoelectric conversion efficiency. Examples of this acceptor dopant include Mg, Ca and C, and Mg is particularly preferable. Although the nitride-based compound semiconductor doped with Mg is not particularly restricted, a nitride-based compound semiconductor containing V, Cr, Mn, Co or Ni is preferred. This is because a favorable crystal can be obtained in combination of V, Cr, Mn, Co and Ni with Mg.

Moreover, the donor dopant normally gives electrons to the base material Al_{1-y}Ga_{y}N to generate electrons as carriers in the conduction band, but in the present invention, the electrons released from the donor dopant enter into the unoccupied portion of the impurity band. It is thereby possible to enhance the photoelectric conversion efficiency. Examples of this donor dopant include H (hydrogen atoms), Si, and O (oxygen atoms).

Further, these acceptor dopant and donor dopant may coexist in the nitride-based compound semiconductor obtained by replacement of part of Al and/or Ga by at least one kind of 3d-transition metals. At this time, a general formula can be expressed by (Al_{1-y}Ga_{y})_{1-x-z-w}TₓA_{z}D_{w}N (0≤y≤1.0, 0.02≤x≤0.3, 0<z≤0.125, 0<w-z<x when w>z, and 0<w≤z when w≤z). This is because, in the case of a donor concentration w being higher than an acceptor concentration z, namely in the case of w > z, (w - z) represents the number of effective donors, and when (w - z) is larger than x, the impurity band is fully occupied, and absorption in two or more stages does not occur.

The nitride-based compound semiconductor as the light-absorbing material of the present invention can absorb light in two or more stages through the impurity band, and has a peak or a tail of light absorption other than direct transition from the valence band to the conduction band. At the peak or the tail, the light absorption coefficient at least in the wavelength region of not longer than 1500 nm and not shorter than 300 nm is not smaller than 1000 cm⁻¹. More preferably, the light absorption coefficient is smaller than 3000 cm⁻¹, and further more preferably not smaller than 5000 cm⁻¹. More preferably, also in the infrared ray region (800 to 2000 nm), the light absorption coefficient is not smaller than 1000 cm⁻¹, further preferably not smaller than 3000 cm⁻¹, and further more preferably not smaller than 5000 cm⁻¹. As the reason for the nitride-based compound semiconductor as the light-absorbing material of the present invention having a high light absorption coefficient, the unoccupied state of the impurity band and the ground state of the electrons are well balanced, meaning that the possibility for transition itself is high, and indicating that the compound semiconductor can realize higher conversion efficiency as the photoelectric conversion material. Herein, the light absorption coefficient indicates a percentage of absorption of light during traveling thereof in a unit length, and the unit is cm⁻¹.

The conventional nitride-based compound semiconductor has a bandgap of 3.4 to 6.2 eV, and a photocurrent is not generated even by irradiation with light having a wavelength not smaller than visible light. As opposed to this, the nitride-based compound semiconductor of the present invention can form at least one or more intermediate bands by impurities, and hence a photocurrent is generated even in the case of irradiation with light having a wavelength not smaller than the visible light.

The nitride-based compound semiconductor of the present invention can be manufactured by a Molecular Beam Epitaxy method (MBE method) using nitrogen-atoms containing gas, such as ammonia or hydrazine, as a nitrogen source. In the case of the GaN-based compound semiconductor, in the MBE method, the nitrogen-atom containing gas is introduced into a vacuum atmosphere, and while the nitrogen-atom containing gas is subjected to photodecomposition or thermal decomposition on the substrate or in the vicinity thereof, the substrate is irradiated with metal molecular beams of Ga and at least one or more of 3d-transition metals T, to make GaTN grow. A concentration of the 3d-transition metal can be changed by adjustment of a temperature of the 3d-transition metal cell at the time of film formation so as to adjust a supplied amount thereof.

Further, the AIN-based compound semiconductor can similarly manufactured by the MBE method. The nitrogen-atom containing gas is introduced into a vacuum atmosphere, and while the nitrogen-atom containing gas is subjected to photodecomposition or thermal decomposition on the substrate or in the vicinity thereof, the substrate is irradiated with metal molecular beams of Al and at least one or more of 3d-transition metals T, to make AlTN grow. Moreover, the GaAlN-based compound semiconductor can similarly manufactured by the MBE method. The substrate is irradiated with metal molecular beams of Al and Ga, and at least one or more of 3d-transition metals T, to make GaAlTN grow.

The nitride-based compound semiconductor used for the present invention can also be produced by a sputtering method. For example, in the case of the GaN-based compound semiconductor, p-GaN or n-GaN, formed on a monocrystal sapphire, is set as a substrate inside a vacuum chamber of a high-frequency sputtering device, and a GaN target is set as opposed thereto. A chip of at least one or more of 3d-transition metals T to be replaced by Ga is installed on the target. An added amount is adjusted, for example, by changing the number of chips. A heater for heating the substrate is installed on the rear surface of a holder for installing the substrate. After air inside the chamber is once exhausted, a mixed gas of Ar-N₂ is introduced and the substrate is heated to a predetermined temperature. High-frequency electric power is then applied to induce plasma, and sputtering film formation is performed for a predetermined period of time. Further, prior to the sputtering film formation, the substrate and the target may be purified in the plasma. Film formation by sputtering can facilitate composition change and is suitable for forming a film with a large area, and is thus suitable for manufacturing the nitride-based compound semiconductor film for use in the present invention. Further, a replacement amount can be arbitrarily adjusted by a method of changing an area, the number or an arrangement of 3d-transition metal chips, or the like. Moreover, the nitride-based compound semiconductor produced by the sputtering method shows a microcrystal or amorphous-like structure.

Furthermore, the AIN-based compound semiconductor can be similarly produced by the sputtering method. p-AlN or n-AlN, formed on a monocrystal sapphire, is installed as a substrate inside a vacuum chamber of a high-frequency sputtering device, and an AlN target is set as opposed thereto. A chip of at least one or more of 3d-transition metals T to be replaced by Al is installed on the target. An added amount was adjusted here by changing the number of chips. A heater for heating the substrate is installed on the rear surface of a holder for setting the substrate. After air inside the chamber was once exhausted, a mixed gas of Ar-N₂ was introduced and the substrate was heated to a predetermined temperature. High-frequency electric power was then applied to induce plasma, and sputtering film formation was performed for a predetermined period of time. Also in the case of GaAlN, production thereof is possible similarly by the sputtering method. Also in this case, film formation is performed by installing GaAlN as a target.

### [Photoelectric conversion element]

A photoelectric conversion element can be produced by use of the light-absorbing material of the present invention. The photoelectric conversion element is an element to absorb optical energy and convert the absorbed energy to electric energy, and includes a light receiving element such as an image pickup element or a photodiode, or a power generation element such as a solar cell. Since the light-absorbing material in the present invention can absorb optical energy in a broad-range wavelength region and convert the absorbed energy to electric energy, it can realize high photoelectric conversion efficiency, and can be suitably used for the power generation element such as a solar cell. Further, it can be suitably used as a material for a light absorbing film for a solar heat power generator, a solar heat water heater, and the like.

The photoelectric conversion element of the present invention is a photoelectric conversion element obtained by formation of a photoelectric conversion layer made up of at least one pn-junction or pan-junction by a plurality of compound semiconductor layers, characterized in that at least one layer of the plurality of compound semiconductor layers is made up of a GaN-based, GaAlN-based or AIN-based compound semiconductor obtained by replacement of Ga and/or Al by at least one kind of 3d-transition metals and having at least one or more impurity bands between a valence band and a conduction band, and a light absorption coefficient in an overall wavelength region of not longer than 1500 nm and not shorter than 300 nm is not smaller than 1000 cm⁻¹.

A compound semiconductor expressed by a general formula Ga₁₋ₓTₓN, (GaAl)₁₋ₓTₓN or Al₁₋ₓTₓN (where (0<x<1)) is a compound semiconductor having a composition formed by replacement of Ga and/or Al in GaN, GaAlN or AlN by a 3d-transition metal T. GaN is a semiconductor having a band gap of 3.4 eV (365 nm) and absorbing ultraviolet light, but not absorbing light having a wavelength not smaller than visible light. Even when it is irradiated with light having a wavelength not smaller than visible light, electrons do not transit from the valence band to the conduction band. Ga₁₋ₓTₓN of the present invention, in the case of being monocrystal, has the same crystal structure as that of GaN. Further, it has an impurity band by T as the replaced 3d-transition metal in the band gap, with the band structure of GaN being in a held state. Herein, T as the 3d-transition metal is not restricted to one kind, but a plurality of 3d-transition metals can be used, and a configuration is formed such that a total of replacement by the plurality of 3d-transition metals is x.

Similarly, AIN is a semiconductor having a band gap of 6.2 eV (200 nm) and absorbing ultraviolet light, but not absorbing light having a wavelength not smaller than visible light. Even when it is irradiated with light having a wavelength not smaller than visible light, electrons do not transit from the valence band to the conduction band. Al₁₋ₓTₓN of the present invention, in the case of being monocrystal, has the same crystal structure as that of AlN. Further, it has an impurity band by T as the replaced 3d-transition metal in the band gap, with the band structure of AlN being in a held state. Similarly, T as the 3d-transition metal is not restricted to one kind, but a plurality of 3d-transition metals can be used, and a configuration is formed such that a total of replacement by the plurality of 3d-transition metals is x.

Similarly, GaAlN is a semiconductor having a band gap of 3.4 to 6.2 eV (200 to 365 nm) and absorbing ultraviolet light, but not absorbing light having a wavelength not smaller than visible light. Even when it is irradiated with light having a wavelength not smaller than visible light, electrons do not transit from the valence band to the conduction band. (GaAl)₁₋ₓTₓN of the present invention, in the case of being monocrystal, has the same crystal structure as that of AIN. Further, it has an impurity band by T as the replaced 3d-transition metal in the band gap, with the band structure of AIN being in a held state. Similarly, T as the 3d-transition metal is not restricted to one kind, but a plurality of 3d-transition metals can be used, and a configuration is formed such that a total of replacement by the plurality of 3d-transition metals is x.

Further, the photoelectric conversion material usable for the photoelectric conversion element of the present invention is made up of a GaN-based, GaAIN-based or AIN-based compound semiconductor obtained by replacement of Ga and/or Al by at least one of 3d-transition metals, and by doping with an acceptor dopant and/or a donor dopant.

The acceptor dopant normally receives electrons from a base material (GaN, GaAlN or AIN) to generate holes in the valence band, but in the present invention, electrons are taken out of the impurity band derived from the 3d-orbit to allow formation of the unoccupied state in the impurity band. It is thereby possible to enhance the catalytic efficiency. Examples of this acceptor dopant include at least one selected from the group consisting of Mg, Ca, and C, and Mg is preferred.

Further, the donor dopant normally gives electrons to the base material (GaN, GaAlN or AIN) to generate electrons as a carrier in the conduction band, but in the present invention, the electrons released from the donor dopant enter into the unoccupied portion of the impurity band. It is thereby possible to enhance the catalytic efficiency. Examples of this donor dopant include at least one selected from the group consisting of Si, O (oxygen atoms) and H (hydrogen atoms).

It goes without saying that these acceptor dopant and donor dopant can coexist in Ga₁₋ₓTₓN, Al₁₋ₓTₓN or (GaAl)₁₋ₓTₓN.

GaTN, GaAlTN or AlTN used for the photoelectric conversion element of the present invention has a similar crystal structure to that of GaN, GaAlN or AlN, thus having a similar lattice constant to that of GaN, GaAlN or AlN in a crystal state, and being able to form a pn-junction with lattice matching. For example, making Ga₁₋ₓTₓN (hereinafter abbreviated as p-GaTN), doped with the acceptor dopant, grow on an n-GaN film can form a hetero pn-junction made up of p-GaTN/n-GaN. Further, making (GaAl)₁₋ₓTₓN (hereinafter abbreviated as p-GaAlTN), doped with the acceptor dopant, grow on an n-GaAlN film can form a hetero pn-junction made up of p-GaAlTN/n-GaAlN. Moreover, making Al₁₋ₓTₓN (hereinafter abbreviated as p-AITN), doped with the acceptor dopant, grow on an n-AlN film can form a hetero pn-junction made up of p-AlTN/n-AlN, Furthermore, p-GaAlTN can be made to grow on the n-GaN film. In a similar manner to this, it is possible to form a pan structure used as an absorber for performing light-absorbing photoelectric conversion on GaTN, GaAlTN or AlN of the present invention.

### Photoelectric conversion element example 1

Hereinafter, there will be described an element example where GaMnN using GaN as a base material and using Mn as a 3d-transition metal was used as a photoelectric conversion material among nitride-based compound semiconductors. Needless to say, a photoelectric conversion material other than the one described in the specification can also be produced in a similar manner and can obtain a similar effect to the present embodiment.

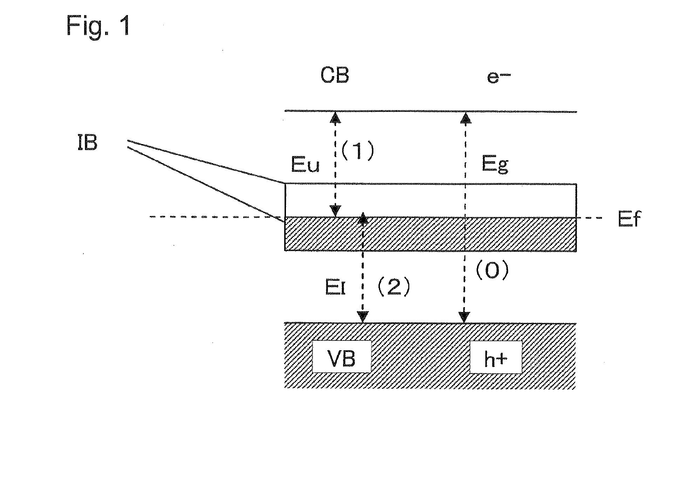

FIG. 1 is a schematic view showing one example of an energy band structure of GaMnN. In the figures, VB denotes a valence band, CB denotes a conduction band, IB denotes an intermediate band made up of an impurity band, E_{g} denotes a band gap of GaMnN, E_{f} denotes a Fermi level, Eᵤ denotes a band gap between the impurity band IB and the conduction band CB, and Eₗ denotes a band gap between the valence band VB and the impurity band IB. By irradiation of GaMnN with sunlight, three types of excitation occurs as follows. 1) While electrons e- are excited from the valence band VB to an the conduction band CB ((0) represented in the figure), 2) electrons e- are excited from the valence band VB to an unoccupied portion of the impurity band IB through the intermediate band IB ((2) represented in the figure), and 3) electrons e- are excited from an occupied portion of the intermediate band IB through the conduction band CB ((1) represented in the figure). By this excitation, a large number of electrons e-come to exist in the conduction band CB, and a large number of holes h⁺ come to exist in the valence band. Since the direct excitation and excitation through the impurity band are possible, a photoelectric conversion material for use in the photoelectric conversion element of the present invention can absorb sunlight in a broad wavelength range as described above, which is not only ultraviolet light but also visible light and infrared light in addition to the ultraviolet light, and can convert solar energy to electric energy with high efficiency. As thus described, the photoelectric conversion material for use in the photoelectric conversion element of the present invention is significantly characterized by having the intermediate band capable of exciting the electrons e-, as described taking GaMnN as an example here. Although one kind, Mn, is used as the 3d-transition metal T, when a plurality of kinds of 3d-transition metals T are used, a plurality of intermediate bands can be formed, and photoelectric conversion efficiency can further be improved.

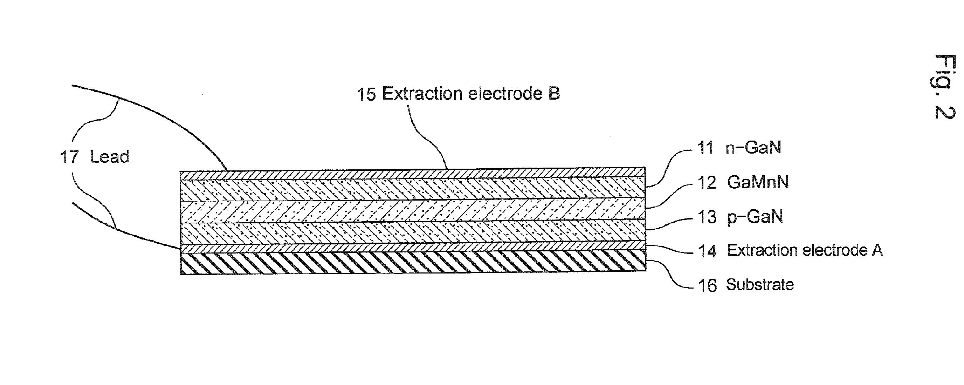

FIG. 2 is a schematic view showing a structure (first solar cell) of a photoelectric conversion element with a pan structure according to the present element example, produced using GaMnN as the photoelectric conversion material. Numeral 16 is a substrate made of a material such as sapphire, silicon, stainless, glass or plastic, and an extraction electrode A14 is formed on the substrate 16 (and a buffer layer is formed on the extraction electrode A14 in some cases, although not shown here). Thereon, a p-GaN layer (p-type gallium nitride) 13, a GaMnN layer 12 for absorbing light and an n-GaN layer (n-type gallium nitride) 11 are film-formed, to form a pan structure. Herein, the GaMnN layer 12 has a pair of opposed principal surfaces. The p-GaN layer 13 is formed on one principal surface in contact therewith, and the n-GaN layer 11 is formed on the other principal surface in contact therewith. Further, an extraction electrode B15 is formed on the n-GaN layer 11. Numeral 17 denote leads as output terminals extracted from the extraction electrodes A and B. Herein, when sunlight is applied from the n-GaN layer 11 side or the substrate 16 side (the substrate needs to be transparent) and the light is incident on the GaMnN layer 12 as a light-absorbing layer, electrons are efficiently excited from the valence band to the conduction band by two types of excitations, which are (1) direct excitation and (2) two-stage excitations through the intermediate band. The excited electrons and the holes move to the surface in an internal field due to the pan structure, and are extracted as electric energy from the lead 17 to the outside.

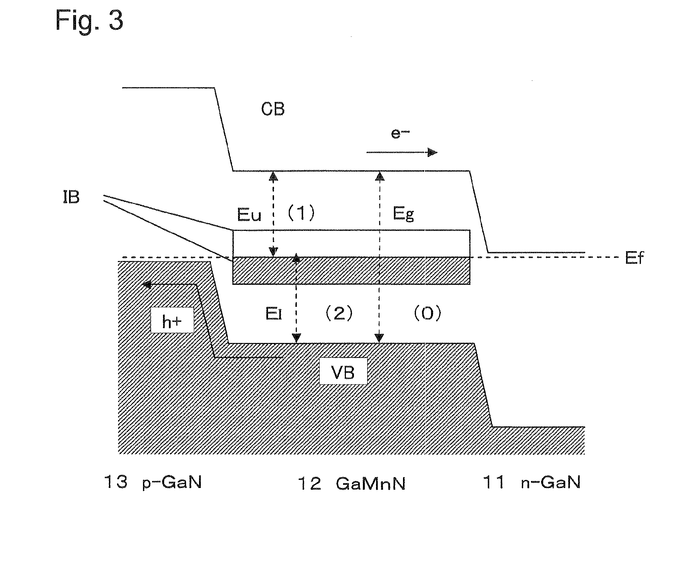

FIG. 3 is a schematic view showing a band structure of the photoelectric conversion element with a pan structure shown in FIG. 2. When the GaMnN layer 12 is irradiated with sunlight, electrons e- are excited from the valence band to the conduction band by the direct excitation (0) from the valence band to the conduction band in an ultraviolet region of the sunlight, and by two-stage light absorption of the excitation (1) and the excitation (2) through the intermediate band in a visible region and an infrared region, and holes h⁺ are then formed in the valence band. The excited electrons e- move to the surface of the n-GaN layer 11 in an internal field due to the pan structure, and the holes h⁺ move to the surface of the p-GaN 13 in the internal field. They are then extracted from the lead 17 to the outside as a current (voltage).

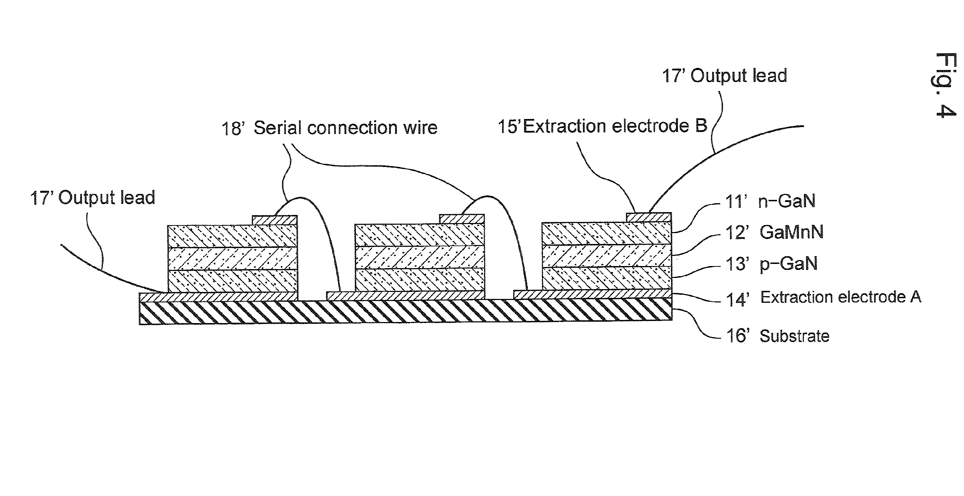

However, an output voltage of one cell (unit) of the photoelectric conversion element as shown in FIG. 2 is low, and a required number of cells need to be connected in series in order to obtain a required amount of voltage for actual use. FIG. 4 shows a structural example of solar cells where three cells are connected in series. Numeral 16' denotes a substrate, and an insulating film is formed on its surface when the substrate is configured of a material having conductivity. An extraction electrode A14' is formed on the substrate 16' in the form of a partial electrode. Thereon, a p-GaN layer 13', a GaMnN layer 12' and an n-GaN layer 11' are each film-formed, and an extraction electrode B15' is further formed, to form one solar cell. A required number of cells are connected in series in order to obtain a required amount of output voltage. In FIG. 4, three cells are formed on the substrate 16', and these cells are connected in series by means of a serial connection wire 18'. When sunlight is applied from the n-GaN layer 11' side or the substrate 16' side (the substrate 16' needs to be transparent in this case) and the light is incident on the GaMnN layer 12', photoelectric conversion is performed, and light can be extracted as a serial voltage from an output lead 17' due to each cell being connected in series.

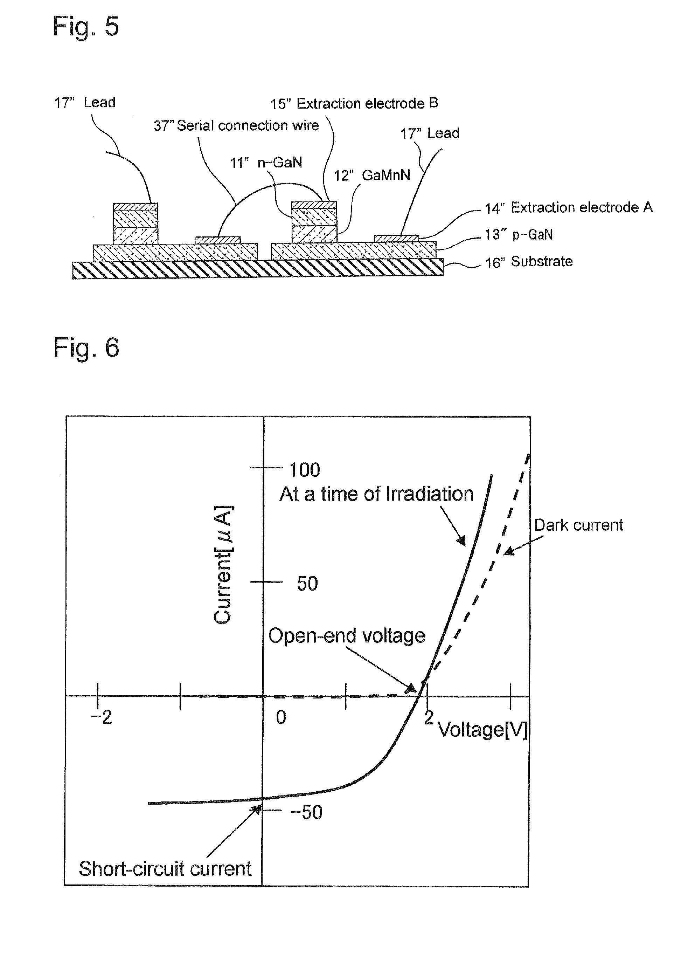

FIG. 5 shows another structural example of a photoelectric conversion element where a plurality of cells (two cells in the figure) are connected in series. On a substrate 16" (a buffer layer is formed thereon depending on a material of the substrate although not shown here), a p-GaN layer 13" is film-formed, and a GaMnN layer 12" and an n-GaN layer 11 are sequentially film-formed. An extraction electrode A14" is formed on the p-GaN layer 13", and an extraction electrode B15" is formed on the n-GaN layer 11", to form one solar cell. A required number of cells are formed and connected in series in order to obtain a required amount of voltage. In FIG. 5, two cells are formed on the substrate 16", and these cells are connected in series by means of a serial connection wire 18". When the GaMnN layer 12" is irradiated with sunlight from the n-GaN layer 11 side or the substrate 16 side (the substrate needs to be transparent), photoelectric conversion is performed, and a serial voltage can be extracted from an output lead 17".

FIG. 6 is a voltage-current characteristic at the time of irradiating a sample of one cell structure of the photoelectric conversion element shown in FIG. 2, 4 or 5 with optical energy of AM-1.5 (corresponding to sunlight on the ground), and from the figure, an open-end (open-circuit) voltage was about 1.95 V, and a short-circuit current was about 45 pA. Herein, an output current value (short-circuit current value) increases in proportion to an area.

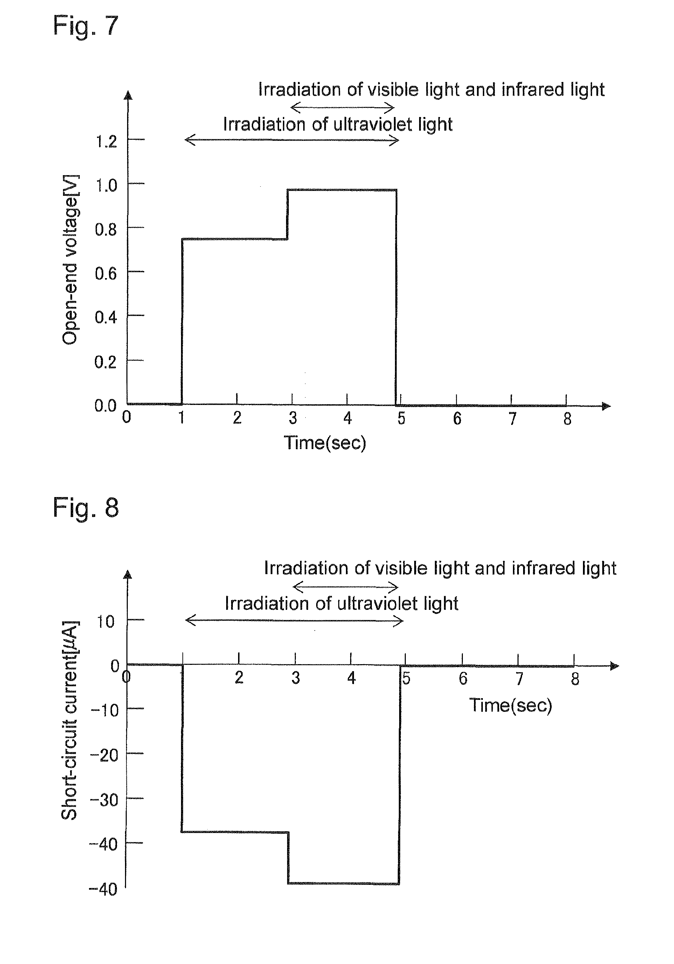

FIG. 7 is a time variation characteristic of an open-end voltage at the time of irradiating a sample of one cell structure of the photoelectric conversion element shown in FIG. 2, 4 or 5 with ultraviolet light and visible light + infrared light. In the figure, when the GaMnN photoelectric conversion material is first irradiated with ultraviolet light, electrons are directly excited from the valence band VB to the conduction band CB, to generate an open-end voltage at an external terminal. Next, when visible light + infrared light are applied while ultraviolet light is kept applied, excitation of electrons from the valence band VB to an unoccupied portion of the impurity band IB through the intermediate band IB and excitation of the electrons from an occupied portion of the intermediate band IB to the conduction band CB occur, to generate a higher open-end voltage as being superimposed on the foregoing generated voltage.

FIG. 8 is a short-circuit current characteristic at the time of irradiating a sample having one cell structure of the solar cell shown in FIG. 2, 4 or 5 with light. In the figure, when the GaMnN photoelectric conversion material is first irradiated with ultraviolet light, electrons are directly excited from the valence band VB to the conduction band CB, to allow a short-circuit current to flow to the outside. Next, when irradiation with visible light + infrared light is performed while irradiation with ultraviolet light remains performed, excitation of electrons from the valence band VB to an unoccupied portion of the impurity band IB through the intermediate band IB and excitation of the electrons from an occupied portion of the intermediate band IB to the conduction band CB occur, to generate a higher short-circuit current as being superimposed on the foregoing short-circuit current.

FIGS. 7 and 8 show that photoelectric conversion by means of visible light and infrared light occur as being superimposed on photoelectric conversion by means of ultraviolet light. It is to be noted that, although irradiation with visible light + infrared light is performed after irradiation with ultraviolet light in FIGS. 7 and 8, a similar result is obtained when irradiation with ultraviolet light is performed after irradiation with visible light + infrared light. Further, even by irradiation with single light of visible light or infrared light, a similar effect is obtained. These results of experiments verify that GaMnN for use in the solar cell of the present invention has an intermediate band by means of impurities, and can absorb light in two or more stages through this impurity band, and that light absorption is performed in a manner other than direct transition from the valence band to the conduction band of GaN, which allows excitation of electrons from the valence band to the conduction band.

Although the GaN-based compound semiconductor obtained by replacement of part of Ga by Mn is used here as the photoelectric conversion material, a GaN-based compound semiconductor obtained by replacement of part of Ga by Mn and by doping with an acceptor dopant and/or a donor dopant can be similarly used. Further, a similar result is obtained for even a nitride-based compound semiconductor obtained by replacement of Ga and/or Al by at least one kind of 3d-transition metals, or a nitride-based compound semiconductor obtained by replacement of Ga and/or Al by at least one kind of 3d-transition metals and by doping with an acceptor dopant and/or a donor dopant, and having at least one or more impurity bands between a valence band and a conduction band.

It should be noted that, needless to say, a photoelectric conversion element in practical use requires a front surface protective member, a filler, a rear surface protective member, a frame, and the like, although not shown in FIG. 2. As the front surface protective member, tempered glass, heat-resistant transparent plastic, a transparent film, or the like can be used. As the filler, EVA or the like can be used. As the rear surface protective member, a plastic film, a metal plate, a plastic plate, tempered glass or the like can be used. Further, as the frame, aluminum, iron or the like can be used.

### Photoelectric conversion element example 2

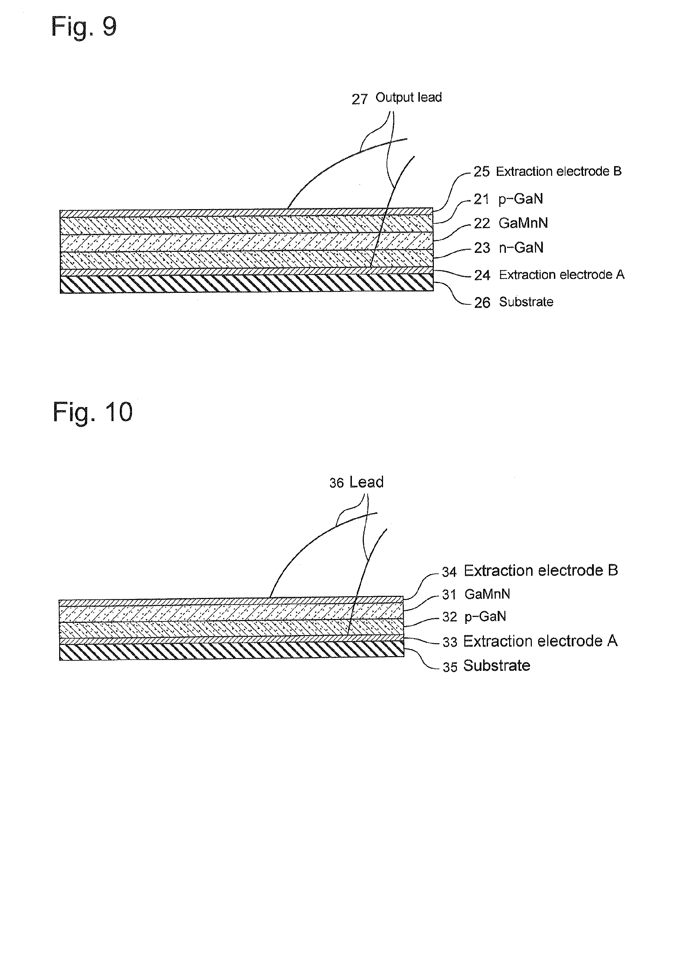

FIG. 9 is a schematic view showing a structure (second solar cell) of a photoelectric conversion element with a pan structure according to the present element example, produced using GaMnN as the photoelectric conversion material. Numeral 26 is a substrate made of a material such as sapphire, silicon, stainless, glass or plastic, and an extraction electrode A24 is formed on the substrate 26 (and a buffer layer is formed in some cases, although not shown here). Thereon, an n-GaN layer 23, a GaMnN layer 22 and a p-GaN layer 21 are film-formed, to form a pan structure. Further, an extraction electrode B25 is formed. Numeral 27 denote leads extracted from the extraction electrodes A and B. When the GaMnN layer 22 is irradiated with sunlight from the p-GaN layer 21 side or the substrate 26 side (the substrate needs to be transparent in this case), electrons are excited from the valence band to the conduction band by direct excitation and two-stage excitation through the intermediate band. The excited electrons and the holes move to the surface in an internal field due to the pan structure, and are extracted as electric energy from the lead 27 to the outside.

A schematic view of a band structure of a solar cell with a pan structure shown in FIG. 9 is similar to that of FIG. 3. When the GaMnN 22 is irradiated with sunlight, electrons are excited from the valence band to the conduction band by the direct excitation (0) from the valence band to the conduction band in an ultraviolet region of the sunlight, and by two-stage light absorption of the excitation (1) and the excitation (2) through the intermediate band in a visible region and an infrared region, and holes are then formed in the valence band. The excited electrons e- move to the surface of the n-GaN layer 11 in an internal field due to the pan structure, and the holes h⁺ move to the surface of the p-GaN layer 13 in the internal field. They are then extracted from the lead 27 to the outside as a current. Although not shown here, a solar cell with a serial connection structure is similar to that of the element example 1, a voltage-current characteristic is also similar to that shown in FIG. 6, of the element example 1, and an output open-end voltage and an output short-circuit current by irradiation with ultraviolet light and with visible light + infrared light are also similar to those shown in FIGS. 7 and 8 of the element example 1.

Although the GaN-based compound semiconductor obtained by replacement of part of Ga by Mn is used here as the photoelectric conversion material, a GaN-based compound semiconductor obtained by replacement of part of Ga by Mn and by doping with an acceptor dopant and/or a donor dopant can be similarly used. Further, a similar result is obtained for even a nitride-based compound semiconductor obtained by replacement of Ga and/or Al by at least one kind of 3d-transition metals, or a nitride-based compound semiconductor obtained by replacement of Ga and/or Al by at least one kind of 3d-transition metals and by doping with an acceptor dopant and/or a donor dopant, and having one or more impurity bands between a valence band and a conduction band.

It should be noted that, needless to say, a photoelectric conversion element in practical use requires a front surface protective member, a filler, a rear surface protective member, a frame, and the like, although not shown in FIG. 9. As the front surface protective member, tempered glass, transparent plastic, a transparent film, or the like can be used. As the filler, EVA or the like can be used. As the rear surface protective member, a plastic film, a metal plate, a plastic plate, tempered glass or the like can be used. Further, as the frame, aluminum or the like can be used.

### Photoelectric conversion element example 3

FIG. 10 is a schematic view showing a structure (third solar cell) of a photoelectric conversion element with a pn structure according to the present element example, produced using GaMnN as the photoelectric conversion material. Numeral 35 is a substrate made of a material such as sapphire, silicon, stainless, glass or plastic, and an extraction electrode A33 is formed on the substrate 35 (and a buffer layer is formed in some cases, although not shown here). Thereon, a p-GaN layer 32, and a GaMnN layer 31 doped with a donor dopant such as hydrogen atoms, Si or oxygen atoms are film-formed. Further, a GaMnN film, film-formed by the sputtering method, can be used as it is. Moreover, an extraction electrode B34 is formed. Numeral 36 denote leads extracted from the extraction electrodes A and B. When sunlight is applied from the GaMnN layer 31 side or the substrate 35 side (the substrate needs to be transparent), in the GaMnN layer 31, electrons are excited from the valence band to the conduction band by direct excitation and two-stage excitation through the intermediate band. The excited electrons and the holes move to the surface in an internal field, and are extracted as electric energy from the lead 36 to the outside.

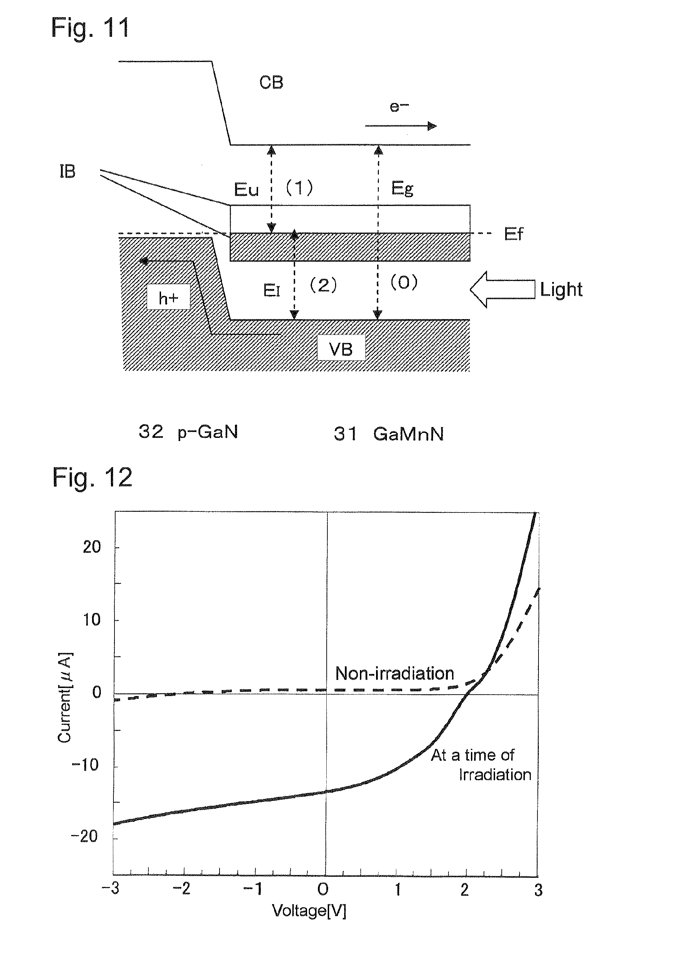

FIG. 11 is a schematic view showing a band structure of the photoelectric conversion element with a pn structure shown in FIG. 10. When the GaMnN layer 31 is irradiated with sunlight, electrons are excited from the valence band to the conduction band by the direct excitation (0) from the valence band to the conduction band in an ultraviolet region of the sunlight, and by two-stage light absorption of the excitation (1) and the excitation (2) through the intermediate band in a visible region and an infrared region, and holes h⁺ are then formed in the valence band. The excited electrons e- move to the surface of the GaMnN layer 31 in the internal field, and the holes h⁺ move to the surface of the p-GaN 13 in the internal field. They are then extracted from the lead 36 to the outside as a current.

FIG. 12 is a voltage-current characteristic at the time of irradiating a sample of one cell structure of the pn-type photoelectric conversion element where (Al_{0.1}Ga_{0.9})_{0.9}Ni_{0.1}N is film-formed on the p-GaN layer with optical energy of AM-1.5 (corresponding to sunlight on the ground), and from the figure, an open-end voltage was about 2,0 V, and a short-circuit current was about 14 µA. Herein, an output current value (short-circuit current value) increases in proportion to an area.

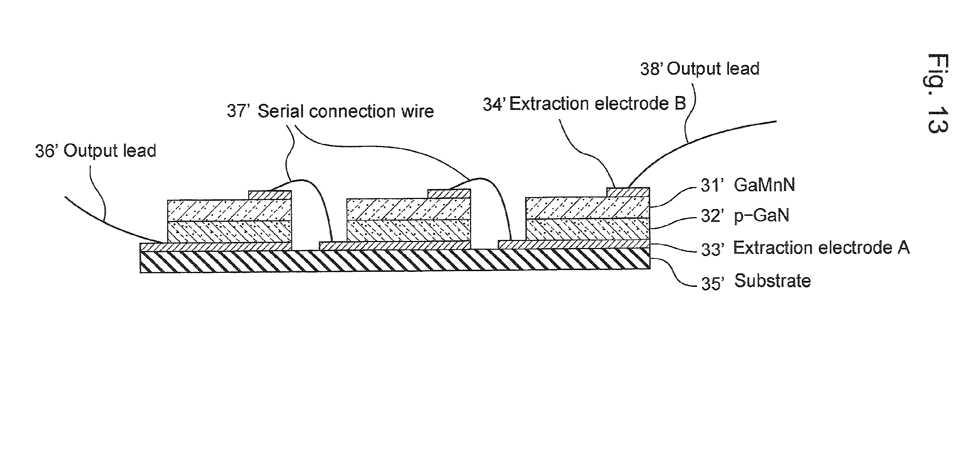

Also in the present element example, an output voltage of one cell (unit) of the photoelectric conversion element is low, and a required number of cells need to be connected in series in order to obtain a required amount of voltage for actual use. There can then be considered a structural example of a photoelectric conversion element connected in series similar to that of the element example 1. FIG. 13 shows a structural example of a photoelectric conversion element where a plurality of cells are connected in series. Numeral 35' denotes a substrate, and an insulating film is formed on its surface when the substrate has conductivity. An extraction electrode A33' is formed on the substrate 35', and thereon, a p-GaN layer 32' and a GaMnN layer 31' are film-formed. Further, an extraction electrode B34' is formed, and one solar cell is formed. A required number of cells are connected in series in order to obtain a required amount of voltage. In FIG. 12, three cells are formed on the substrate 35', and these cells are connected in series by means of a serial connection wire 37'. When the GaMnN layer 31' is irradiated with sunlight from the GaMnN layer 31' side or the substrate 35' side (the substrate needs to be transparent), photoelectric conversion is performed, and a voltage (current) can be extracted from an output lead 36'.

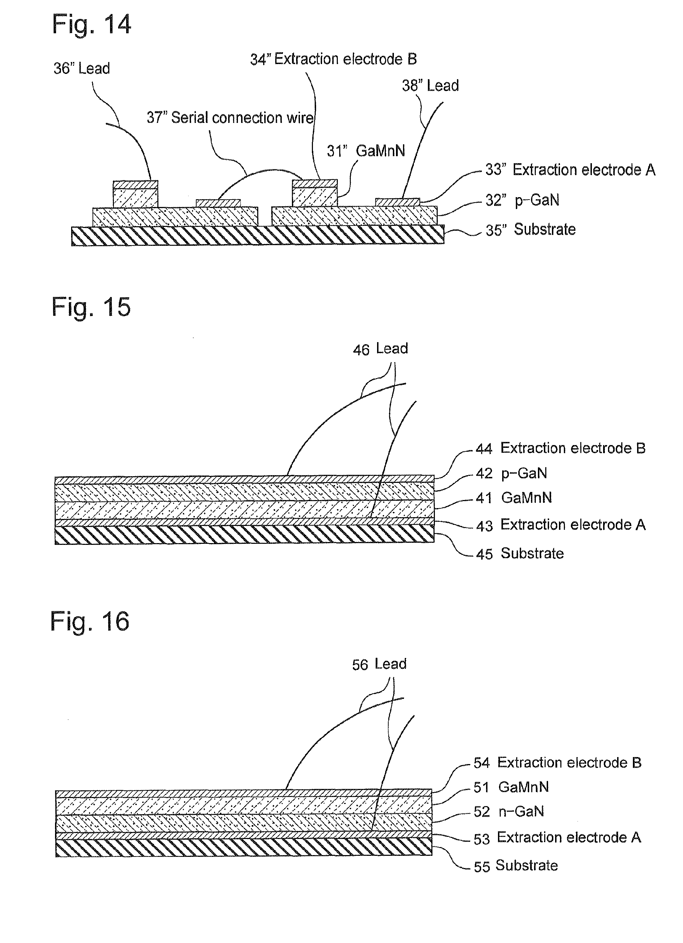

FIG. 14 is schematic view showing another structure of a photoelectric conversion element where a plurality of cells are connected in series. On a substrate 35", a p-GaN layer 32" and a GaMnN layer 31" are film-formed. An extraction electrode A33" is formed on the p-GaN layer 32", and an extraction electrode B34" is formed on the GaMnN layer 31", to form one solar cell. A required number of cells are connected in series in order to obtain a required amount of voltage. In FIG. 13, two cells are formed on the substrate 35", and these cells are connected in series by means of a serial connection wire 37". When the GaMnN layer 31" is irradiated with sunlight, photoelectric conversion is performed, and a voltage (current) can be extracted from an output lead 36".

Although GaMnN obtained by replacement of part of Ga by Mn and by doping with the donor dopant is used here as the photoelectric conversion material, a GaN-based compound semiconductor obtained by replacement of part of Ga by Mn and by doping with an acceptor dopant and a donor dopant can be similarly used. Further, another 3d-transition metal can be used in place of Mn. Although AlGaNiN is used here as a GaAlN-based compound semiconductor obtained by replacement of part of Ga and/or Al by at least one kind of 3d-transition metals and by doping with a donor dopant, a GaAlN-based compound semiconductor obtained by replacement of part of Ga and/or Al by at least one kind of 3d-transition metals and by doping with an acceptor dopant and a donor dopant can be similarly used. Further, AITN obtained by replacement of part of Al by T and by doping with a donor dopant, or an AIN-based compound semiconductor obtained by replacement of part of Al by T and by doping with an acceptor dopant and a donor dopant, can be similarly used.

It should be noted that, needless to say, a solar cell in practical use requires a front surface protective member, a filler, a rear surface protective member, a frame, and the like, although not shown in FIG. 10. As the front surface protective member, tempered glass, transparent plastic, a transparent film, or the like can be used. As the filler, EVA or the like can be used. As the rear surface protective member, a plastic film, a metal plate, a plastic plate, tempered glass or the like can be used. Further, as the frame, aluminum or the like can be used.

### Photoelectric conversion element example 4

FIG. 15 is a schematic view showing a structure (fourth solar cell) of a photoelectric conversion element with a pn structure according to the present element example, produced using GaMnN as the photoelectric conversion material. An extraction electrode A43 (and a buffer layer is formed in some cases, although not shown here) is formed on a substrate 45, and thereon, a GaMnN layer 41 doped with a donor dopant such as hydrogen atoms, Si or oxygen atoms, p-GaN layer 42 are film-formed. Further, a GaMnN film, film-formed by the sputtering method, can be used as it is. Further, an extraction electrode B44 is formed. Numeral 46 denote leads extracted from the extraction electrodes A and B. When sunlight is applied from the p-GaN layer 42 side or the substrate 45 side (the substrate needs to be transparent), in the GaMnN layer 41, electrons are excited from the valence band to the conduction band by direct excitation and two-stage excitation through the intermediate band. The excited electrons move to the surface in an internal field, and are extracted as a voltage (current) from the lead 46.

It is to be noted that, although an example of serial connection is not described here, also in the case of the present element example, an output voltage of one cell (unit) of the photoelectric conversion element is low, and a plurality of cells need to be connected in series in order to obtain a required amount of voltage for actual use, and a configuration can be formed in a similar manner to the case of the element example 3.

Although the GaN-based compound semiconductor obtained by replacement of part of Ga by Mn and by doping with the donor dopant is used here as the photoelectric conversion material, a GaN-based compound semiconductor obtained by replacement of part of Ga by Mn and by doping with an acceptor dopant and a donor dopant can be similarly used. Further, a similar result is obtained for even a nitride-based compound semiconductor obtained by replacement of Ga and/or Al by at least one kind of 3d-transition metals and by doping with the donor dopant, or a nitride-based compound semiconductor obtained by replacement of Ga and/or Al by at least one kind of 3d-transition metals and by doping with an acceptor dopant and a donor dopant, and having at least one or more impurity bands between a valence band and a conduction band.

It should be noted that, needless to say, a solar cell in practical use requires a front surface protective member, a filler, a rear surface protective member, a frame, and the like, although not shown in FIG. 15. As the front surface protective member, tempered glass, transparent plastic, a transparent film, or the like can be used. As the filler, EVA or the like can be used. As the rear surface protective member, a plastic film, a metal plate, a plastic plate, tempered glass or the like can be used. Further, as the frame, aluminum or the like can be used.

### Photoelectric conversion element example 5

FIG. 16 is a schematic view showing a structure (fifth solar cell) of a solar cell with a pn structure according to the present element example, produced using GaMnN as the photoelectric conversion material. Numeral 55 is a substrate made of a material such as sapphire, silicon, stainless, glass or plastic, and an extraction electrode A53 is formed on the substrate 55 (and a buffer layer is formed in some cases, although not shown here). Thereon, a n-GaN layer 52, and further a GaMnN layer 51 doped with an acceptor dopant such as Mg, Ca or C, are film-formed. Further, a GaMnN film, film-formed by the MBE method, can be used as it is. Moreover, an extraction electrode B54 is formed. Numeral 56 denote leads extracted from the extraction electrodes A and B. When sunlight is applied from the GaMnN layer 51 side or the substrate 56 side (the substrate needs to be transparent), in the GaMnN layer 51, electrons are excited from the valence band to the conduction band by direct excitation and two-stage excitation through the intermediate band. The excited electrons move to the surface in an internal field, and are extracted as a voltage (current) from the lead 56.

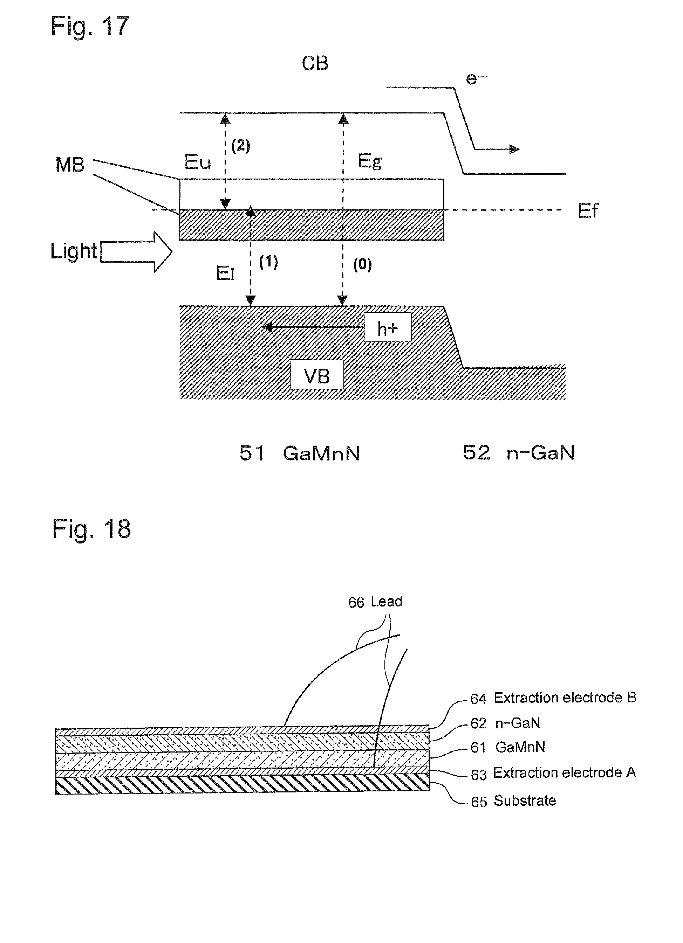

FIG. 17 is a schematic view showing a band structure of the photoelectric conversion element shown in FIG. 16. When the GaMnN 51 is irradiated with sunlight, electrons are excited from the valence band to the conduction band by the direct excitation (0) from the valence band to the conduction band in an ultraviolet region of the sunlight, and by two-stage light absorption of the excitation (1) and the excitation (2) through the intermediate band in a visible region and an infrared region, and holes h⁺ are then formed in the valence band. The excited electrons e- move to the surface of the n-GaN layer 52 in an internal field, and the holes h⁺ move to the surface of the GaMnN layer 51 in the internal field. They are then extracted from the lead 56 to the outside as a voltage (current).

It is to be noted that, although an example of serial connection is not described here, also in the case of the present element example, an output voltage of one cell (unit) of the photoelectric conversion element is low, and a plurality of cells need to be connected in series in order to obtain a required amount of voltage for actual use, and a configuration can be formed in a similar manner to the case of the element example 3.

Although the GaN-based compound semiconductor obtained by replacement of part of Ga by Mn and by doping with the donor dopant is used here as the photoelectric conversion material, a GaN-based compound semiconductor obtained by replacement of part of Ga by Mn and by doping with an acceptor dopant and a donor dopant can be similarly used. Further, a similar result is obtained for even a nitride-based compound semiconductor obtained by replacement of Ga and/or Al by at least one kind of 3d-transition metals and by doping with the donor dopant, or a nitride-based compound semiconductor obtained by replacement of Ga and/or Al by at least one kind of 3d-transition metals and by doping with an acceptor dopant and a donor dopant, and having at least one or more impurity bands between a valence band and a conduction band.

It should be noted that, needless to say, a solar cell in practical use requires a front surface protective member, a filler, a rear surface protective member, a frame, and the like, although not shown in FIG. 16. As the front surface protective member, tempered glass, transparent plastic, a transparent film, or the like can be used. As the filler, EVA or the like can be used. As the rear surface protective member, a plastic film, a metal plate, a plastic plate, tempered glass or the like can be used. Further, as the frame, aluminum or the like can be used.

### Photoelectric conversion element example 6

FIG. 18 is a schematic view showing a structure (sixth solar cell) of a photoelectric conversion element according to the present element example, produced using GaMnN as the photoelectric conversion material. Numeral 65 is a substrate made of a material such as sapphire, silicon, stainless, glass or plastic, and an extraction electrode A63 is formed on the substrate 65 (and a buffer layer is formed in some cases, although not shown here). Thereon, a GaMnN layer 61 doped with an acceptor dopant such as Mg, Ca or C, and further a n-GaN layer 62, are film-formed. Further, a GaMnN film, film-formed by the MBE method, can be used as it is. Further, an extraction electrode B64 is formed. Numeral 66 denote leads extracted from the extraction electrodes A and B. When sunlight is applied from the n-GaN layer 62 side or the substrate 66 side (the substrate needs to be transparent), in the GaMnN layer 61, electrons are excited from the valence band to the conduction band by direct excitation and two-stage excitation through the intermediate band. The excited electrons move to the surface in an internal field, and are extracted as a voltage (current) from the lead 66.

It is to be noted that, although an embodiment of serial connection is not described here, also in the case of the present element example, an output voltage of one cell (unit) of the photoelectric conversion element is low, and a plurality of cells need to be connected in series in order to obtain a required amount of voltage for actual use, and a configuration can be formed in a similar manner to the case of the element example 3.

Although the GaN-based compound semiconductor obtained by replacement of part of Ga by Mn and by doping with the acceptor dopant is used here as the photoelectric conversion material, a GaN-based compound semiconductor obtained by replacement of part of Ga by Mn and by doping with an acceptor dopant and a donor dopant can be similarly used. Further, a similar result is obtained for even a nitride-based compound semiconductor obtained by replacement of Ga and/or Al by at least one kind of 3d-transition metals and by doping with the acceptor dopant, or a nitride-based compound semiconductor obtained by replacement of Ga and/or Al by at least one kind of 3d-transition metals and by doping with an acceptor dopant and a donor dopant, and having at least one or more impurity bands between a valence band and a conduction band.

It should be noted that, needless to say, a solar cell in practical use requires a front surface protective member, a filler, a rear surface protective member, a frame, and the like, although not shown in FIG. 18. As the front surface protective member, tempered glass, transparent plastic, a transparent film, or the like can be used. As the filler, EVA or the like can be used. As the rear surface protective member, a plastic film, a metal plate, a plastic plate, tempered glass or the like can be used. Further, as the frame, aluminum or the like can be used.

### EXAMPLES

### <Example 1> (Production of (Al_{1-y}Ga_{y})₁₋ₓTₓN film)

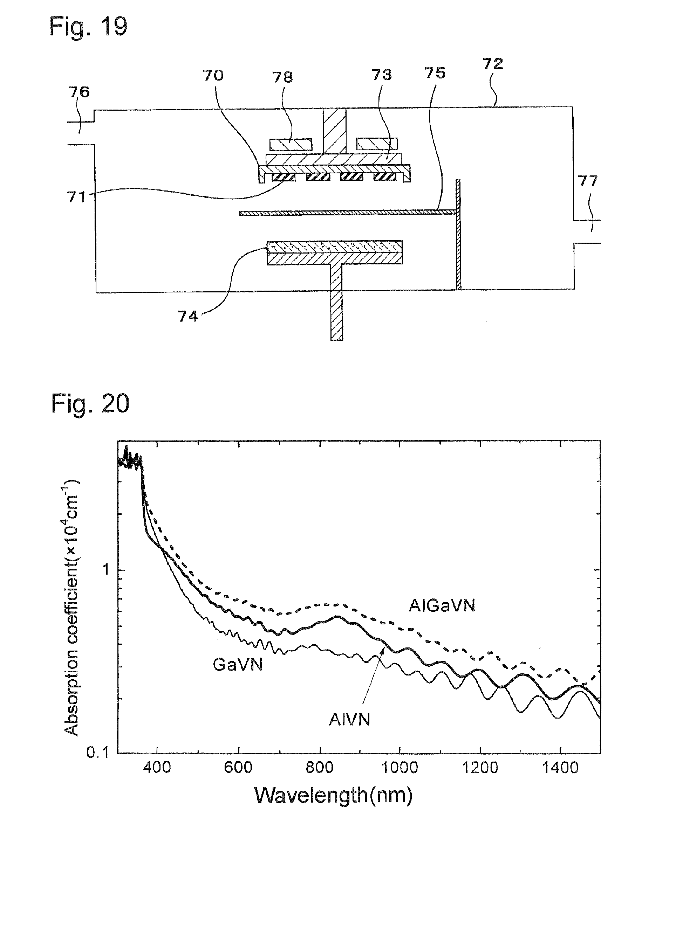

An (Al_{1-y}Ga_{y})₁₋ₓTₓN film was produced using a sputtering device shown in FIG. 19. This device has a vacuum chamber 72, and on the side wall thereof, a gas introduction nozzle 76 for introducing a sputtering gas, and an exhaust outlet 77 are arranged. A mixed gas of an argon gas and a nitrogen gas was used as the sputtering gas. Inside the vacuum chamber 72, a target 74 is arranged on a cathode, and a plurality of substrates 71 is arranged in a substrate holder 70 opposed to the target. For the target, a mixed crystal of a Al/Ga ratio of 0.1/0.9 was used. A chip of any of V, Cr, Mn, Co and Ni was installed on the target as a 3d-transition metal chip (not shown). The 3d-transition metal chip is sputtered simultaneously with (AlGa)N, and also reacted with nitrogen contained in the sputtering gas, and Al and Ga elements in the produced (AlGa)N film are replaced by the 3d-transition metal. A replacement amount can be adjusted as appropriate by changes in size and number of chips. As the substrate, sapphire, silicon, quartz, GaN or the like can be used, but herein, a substrate obtained by previously forming a GaN film on a sapphire monocrystal is used. A heater 78 is installed on the rear surface of the substrate holder 70, to allow heating of the substrate.

With a shutter 75 being in a closed state, the inside of the chamber is evacuated and a current is applied to the heater to generate heat. When a substrate temperature reaches 300°C, the mixed gas of argon and nitrogen is introduced as the sputtering gas. A mixed ratio between argon and nitrogen is adjustable, and herein, a Ar/N₂ ratio was set to the range of 1/1 to 4/1. Thereafter, a high frequency is applied to generate an electric glow discharge, and a shutter is opened to deposit an (AlGa) TN film on the substrate. A film formation speed differs depending on the Ar/N₂ ratio, and when the Ar/N₂ ratio was 2/1, the film formation speed was about 11 nm/min.

The obtained (Al_{1-y}Ga_{y})₁₋ₓTₓN film was subjected to composition analysis by Rutherford backscattering spectrometry, to measure a replacement amount of the 3d-transition metal.

### (Measurement of light absorption spectrum)

A light absorption spectrum was measured using an ultra-violet and visible spectrophotometers (UV-3600 and SOLID Spec-3700 made by Shimadzu Corporation)

FIGS. 20 to 24 are graphs showing light absorption spectrums of samples obtained by replacement of Al and/or Ga by a variety of 3d-transition metals in the (Al_{1-y}Ga_{y})₁-ₓTₓN film of the present invention.

FIG. 20 is light absorption spectrums of samples obtained by replacement of Al and/or Ga in AIN, Al_{0.1}Ga_{0.9}N and GaN by V (5%). Chemical composition formulas of AlVN, AlGaVN and GaVN in the figure are respectively Al_{0.95}V_{0.05}N, (Al_{0.1}Ga_{0.9})_{0.95}V_{0.05}N and Ga_{0.95}V_{0.05}N. In any compound containing Al, an absorption peak was observed in the vicinity of a wavelength of 800 nm, and it had an absorption coefficient of not smaller than 2000 cm⁻¹ in a wavelength range of 300 to 1500 nm. Further, with regard to the compound not containing Al, the compound containing Al obtained a larger absorption coefficient in a wavelength region of 400 to 1500 nm than the sample not containing Al.

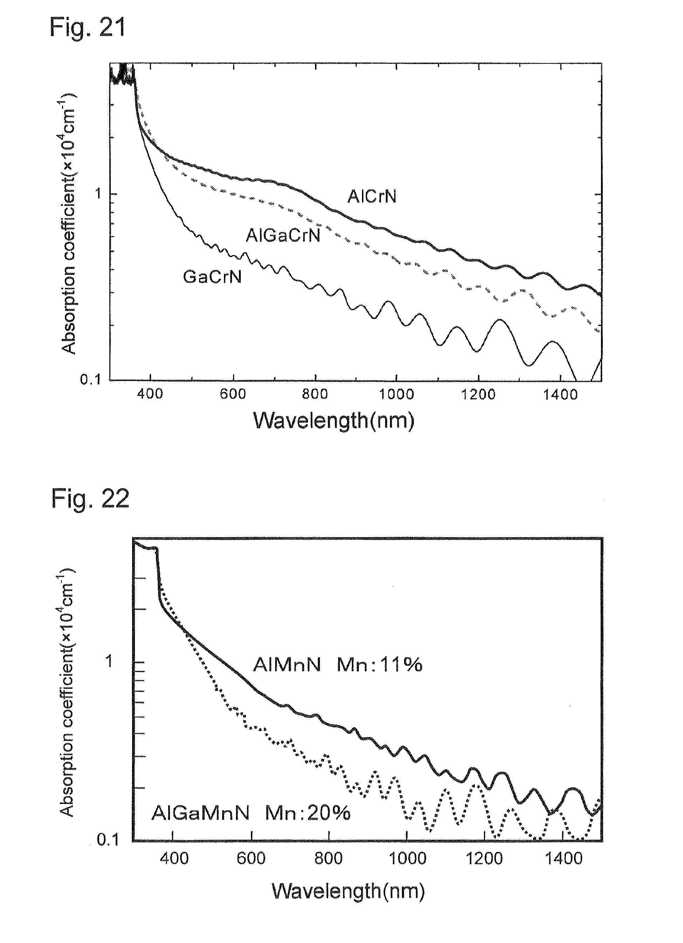

FIG. 21 is light absorption spectrums of samples obtained by replacement of Al and/or Ga in AIN, Al_{0.1}Ga_{0.9}N and GaN by Cr (9%). Chemical composition formulas of AlCrN, AlGaCrN and GaCrN in the figure are respectively Al_{0.91}Cr_{0.09}N, (Al_{0.1}Ga_{0.9})_{0.91}Cr_{0.09}N and Ga_{0.91}Cr_{0.09}N. In any compound containing Al, an absorption tail was observed in the vicinity of a wavelength of 750 nm, and it had an absorption coefficient of not smaller than 2000 cm⁻¹ in a wavelength range of 300 to 1500 nm. Further, with regard to the compound not containing Al, the compound containing Al obtained a larger absorption coefficient in a wavelength region of 400 to 1500 nm than the sample not containing Al.

FIG. 22 is light absorption spectrums of samples obtained by replacement of Al and/or Ga in AIN and Al_{0.1}Ga_{0.9}N by Mn (11%, 20%). Chemical composition formulas of AlMnN and AlGaMnN in the figure are respectively Al_{0.89}Mn_{0.11}N and (Al_{0.1}Ga_{0.9})_{0.80}Mn_{0.20}N. Either shows a high absorption tail in a wavelength region of not shorter than 400 nm, and had an absorption coefficient of not smaller than 1000 cm⁻¹ in a wavelength range of 300 to 1500 nm.

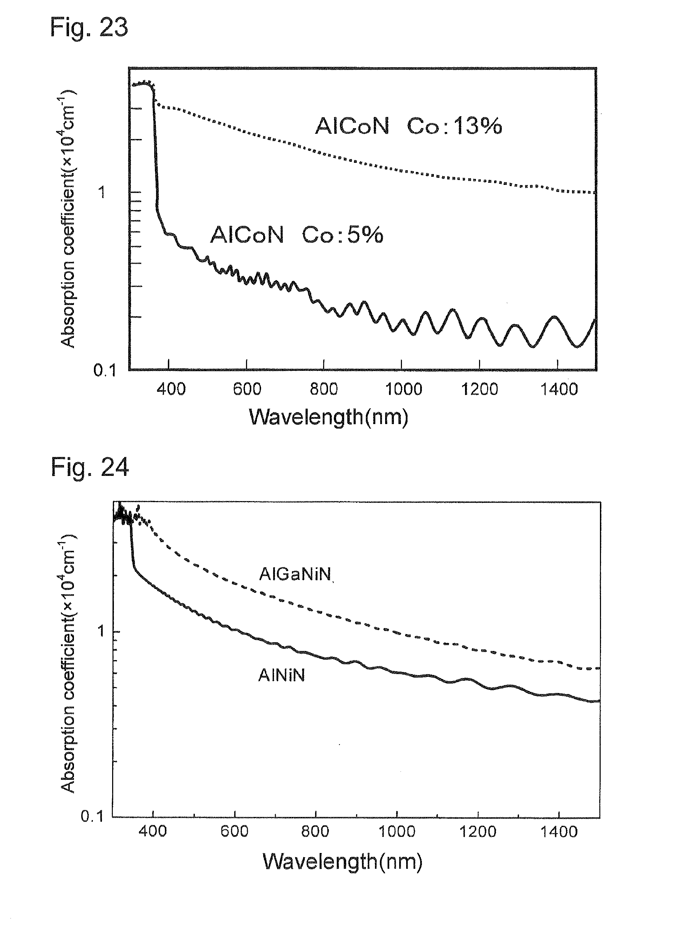

FIG. 23 is light absorption spectrums of samples obtained by replacement of Al in AIN by Co (5%, 13%). Respective chemical composition formulas thereof are Al_{0.95}Co_{0.05}N and Al_{0.87}Co_{0.13}N. Either shows an absorption tail in a wavelength region of not shorter than 400 nm, and had a high absorption coefficient of not smaller than 5000 cm⁻¹ in a wavelength range of 300 to 1500 nm.

FIG. 24 is light absorption spectrums of samples obtained by replacement of Al and/or Ga in AIN and Al_{0.1}Ga_{0.9}N by Ni (10%). Chemical composition formulas of AINiN and AlGaNiN in the figure are respectively Al_{0.90}Ni_{0.10}N and (Al_{0.1}Ga_{0.9})_{0.90}.Ni_{0.10}N. Either shows an absorption tail in a wavelength region of not shorter than 400 nm, and had an absorption coefficient of not smaller than 4000 cm⁻¹ in a wavelength range of 300 to 1500 nm.

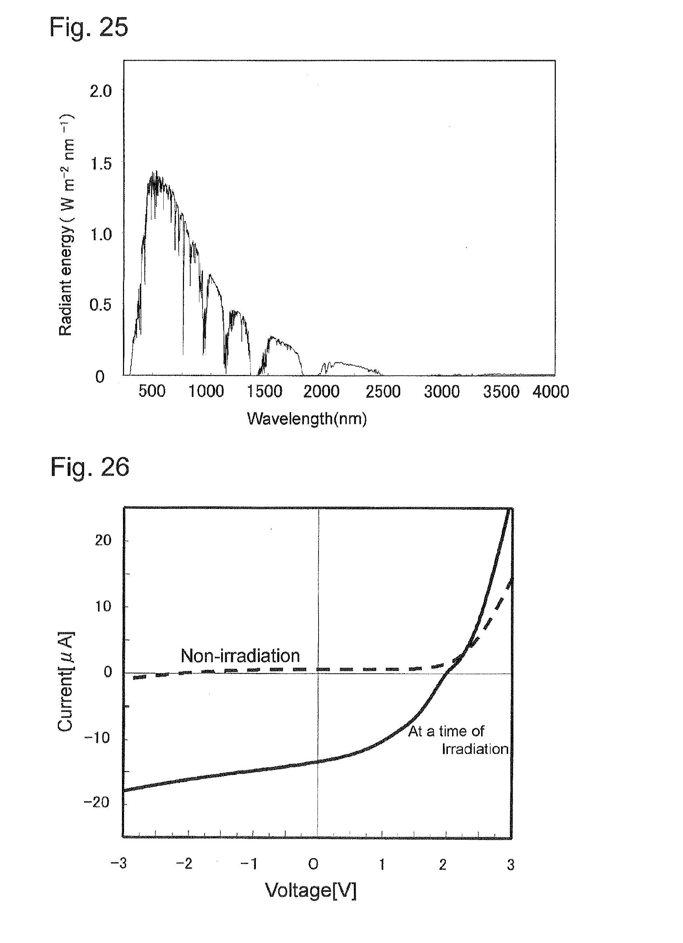

Further, for the sake of reference, FIG. 25 shows a radiant intensity spectrum (AM-1.5) of sunlight on the earth's surface. As apparent from the figure, sunlight has a large irradiance intensity in a wavelength region of 300 to 2000 nm, particularly a wavelength region of 400 to 1500 nm, but since (AlGa)N has a band gap of 3.4 to 6.2 eV, it can hardly absorb light in a wavelength region of not shorter than 365 nm. As opposed to this, it is found that the compound semiconductors of the present invention, obtained by replacement of Al and/or Ga by the 3d-transition metals shown in FIGS. 20 to 24, show high absorption coefficients of 300 to 1500 nm.

### <Example 2> (Production of photoelectric conversion element)

In sputtering film formation of the (Al_{0.1}Ga_{0.9})_{0.90}Ni_{0.10}N layer of Example 1, part of the surface of a p-GaN substrate 2, previously formed on a monocrystal sapphire 1 installed in the substrate holder, is covered by a metal mask to form a non-film formation part, where no sputtering film is produced, on the substrate. After completion of sputtering film formation, electrodes are evaporated respectively on part of the surface of an (Al_{0.1}Ga_{0.9})_{0.90}Ni_{0.10}N layer 3 and the non-film formation part, to form an n-layer electrode 4 and a p-layer electrode 5 so as to produce a photoelectric conversion element.

FIG. 26 shows voltage-current characteristics at the time of irradiation and non-irradiation of a sample of one cell structure of a pn-type photoelectric conversion element, where AlGaNiN is film-formed on p-GaN, with optical energy (corresponding to sunlight on the ground) of AM-1.5. Electric power is not generated at the time of non-irradiation with optical energy, and is generated at the time of irradiation, with an open-end voltage of about 2.0 V and a short-circuit current of about 14 µA.

### <Example 3> (Film formation by MBE method)

A sapphire substrate was installed in a substrate holder inside a vacuum chamber connected to a gas introduction nozzle for introducing an ammonia gas and arranged with evaporation sources of Ga and Mn. A heater is arranged on the rear surface of the substrate holder. A current was applied to the heater to generate heat, and the sapphire substrate was heated to 950 °C to perform clear-up process. Thereafter, a temperature of the sapphire substrate was decreased to 550 °C, and an ammonia gas was issued in a jet from a gas nozzle, to be sprayed to the sapphire substrate. Meanwhile, a first metal material inside a first evaporation source was heated, to generate a metal molecular beam chiefly composed of Ga, and the surface of the sapphire substrate was irradiated with the beam, to form a buffer layer made up of a GaN thin film.

After formation of the buffer layer to have a predetermined film thickness (0.2 µm), the temperature of the sapphire substrate was increased to 720 °C, and a nitrogen-atom containing gas (ammonia gas, here) was sprayed directly to the surface of the buffer layer by means of the gas nozzle, to thermally decompose the layer. Meanwhile, a molecular beam chiefly composed of Ga and a molecular beam chiefly composed of Mn were applied from a Ga evaporation source and an Mn evaporation source toward the buffer layer, to form a GaMnN film on the surface of the buffer layer. A GaMnN film with a thickness of 1 µm was film-formed on conditions that a temperature of the Ga evaporation source was 850 °C, a temperature of the Mn evaporation source was 630 °C and a flow rate of the ammonia gas was 5 sccm.

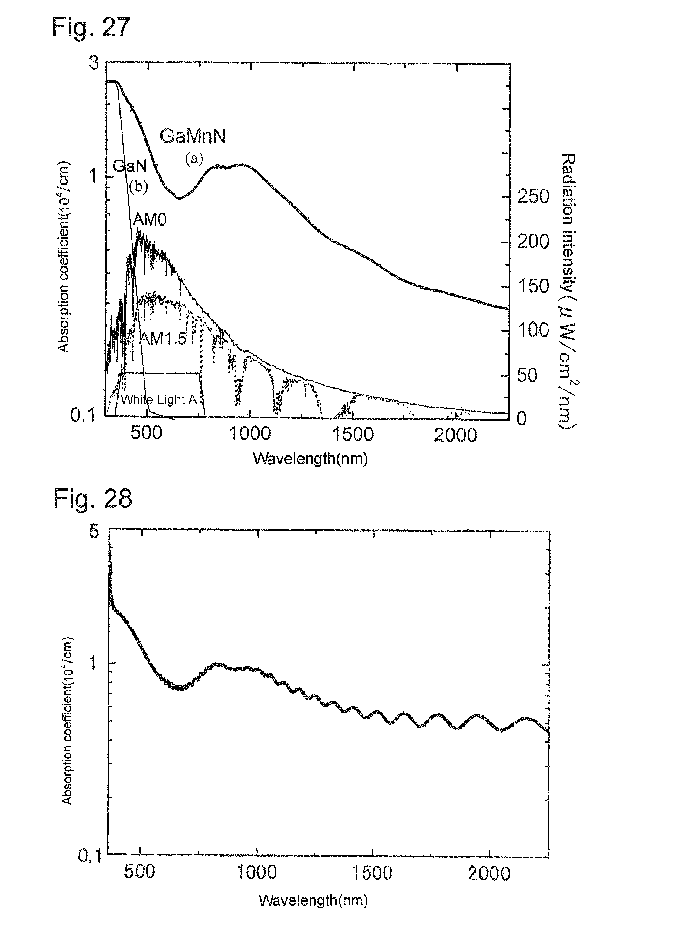

FIG. 27 is one example of a light absorption spectrum of a Ga₁₋ₓMnₓN film (x = 0.082) for use in the present invention. Further, for the sake of reference, the figure shows a radiant intensity spectrum (AM-0: on the earth's orbit, and AM-1.5: on the earth's surface) of sunlight and a radiant intensity spectrum of a white light source (MAX-302, made by Asahi Spectra Co., Ltd.). GaN is not absorbed in a wavelength region of 400 to 2000 nm, whereas the Ga₁₋ₓMnₓN film has an absorption coefficient of not smaller than 8000 cm⁻¹ in a wavelength region of 400 to 1000 nm. Further, the film also absorbs light more than GaN even in the ultraviolet region and the infrared region. Absorption by the impurity band is recognized in a peak structure in a broad region of 1500 to 700 nm, and in a continuous absorption structure with a 700 to 400 nm. Further, as apparent from FIG. 27, the light absorption spectrum of the Ga₁₋ₓMnₓN film has the wavelength region roughly corresponding to that of the radiant intensity spectrum of sunlight, thus allowing effective use of unused light of sunlight.

### <Example 4> (Film formation by MBE method)

A Ga₁₋ₓMnₓN film was produced in a similar manner to Example 3 except that an Mn cell temperature at the time of film formation was adjusted to control an Mn supplied amount. A film thickness was 0.4 µm, and x was 0.05. A light absorption coefficient was not smaller than 1000 cm⁻¹ in a wavelength region of 300 to 1500 nm.

### <Example 5> (Film formation by MBE method)

A Ga_{1-x-z}MnₓMg_{z}N film was produced in a similar manner to Example 4 except that Mg was supplied simultaneously with Ga and Mn at the time of production. A film thickness was 0.4 µm, x was 0.05 and z was 0.02. A light absorption coefficient was not smaller than 1000 cm⁻¹ in a wavelength region of 300 to 1500 nm.

### <Example 6> (Film formation by MBE method)

A Ga₁₋ₓMnₓN:H_{y} film was produced in a similar manner to Example 3 except that, at the time of producing the Ga₁₋ₓMnₓN film, a substrate temperature is set to a low value of the order of 600 °C to suppress part of ammonia decomposition so as to make hydrogen residual. Further, as for the Ga₁₋ₓMnₓN film, which was produced at a high substrate temperature of not lower than 700 °C with no hydrogen becoming residual, hydrogen molecules were thermally decomposed in a hydrogen atmosphere by a hot filament method, and then applied to the Ga₁₋ₓMnₓN film, to produce Ga₁₋ₓMnₓN:H_{y}. A film thickness was 0.3 µm, x was 0.06 and y was 0.03. FIG. 28 shows a light absorption spectrum. The Ga₁₋ₓMnₓN:H_{y} film had an absorption coefficient of not smaller than 7000 cm⁻¹ in a wavelength region of 400 to 1000 nm, and an absorption coefficient of not smaller than 1000 cm⁻¹ in a wavelength region of 300 to 1500 nm. Further, the film also absorbs light more than GaN even in the ultraviolet region and the infrared region. Absorption by the impurity band was recognized in a peak structure in a broad region of 1500 to 700 nm, and in a continuous absorption structure with a 700 to 400 nm. It is to be noted that, although the example of film formation of the photoelectric conversion material by the MBE method and the example at the time of doping the 3d-transition metal into GaN as the characteristic of the above film formation are shown, a similar excellent light absorption characteristic are shown even when the 3d-transition metal is doped into GaAlN or AlN, and those can be used as the photoelectric conversion material for the photoelectric conversion element of the present invention.

### <Example 7> (Film formation by sputtering method)

An example of producing a GaN-based compound semiconductor by a sputtering method will be described. p-GaN or n-GaN, formed on a monocrystal sapphire, is set as a substrate inside a vacuum chamber of a high-frequency sputtering device, and an GaN target is set as opposed thereto. A chip of a 3d-transition metal to be replaced by Ga was installed on the target. An added amount was adjusted here by changing the number of chips. A heater for heating the substrate is set on the rear surface of a holder for setting the substrate. After air inside the chamber was once exhausted, a mixed gas of Ar-N₂ was introduced and the substrate was heated to a predetermined temperature. High-frequency electric power was then applied to induce plasma, and sputtering film formation was performed for a predetermined period of time. Further, prior to the sputtering film formation, the substrate and the target are purified in the plasma.

Chief conditions for sputtering film formation are shown below:
RF power: 200 W
Substrate temperature: 300 °C
Ar: N₂ mixture ratio: 2:1
Film formation speed: 11 nm/min

### (Compound analysis)

The obtained Ga₁₋ₓTₓN film was a film being dense and having flatness and not many defects regardless of addition or non-addition of the 3d-transition metal. The GaN-based compound semiconductor film produced by the sputtering method was subjected to composition analysis by Rutherford backscattering spectrometry, to obtain x in Ga₁₋ₓTₓN. A result of the analysis showed, from analyzed amounts of Ga and the 3d-transition metal and an analyzed amount of nitrogen, that the thin film had become a thin film having a non-stoichiometric composition. Accordingly, part of the 3d-transition metal element may not have replaced a Ga position, and its detail is currently under study.

### (Result)

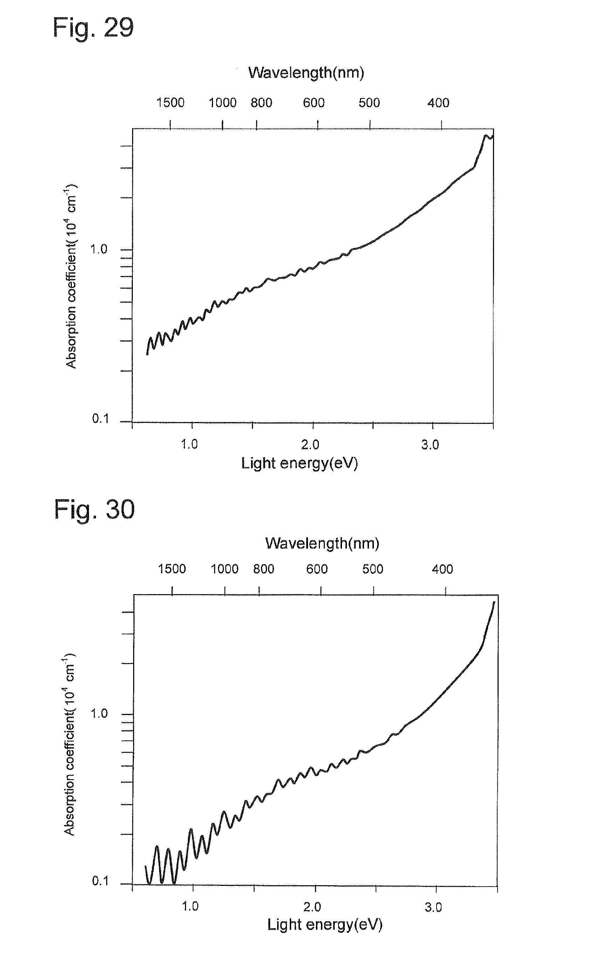

A light absorption spectrum of the thin film, film-formed by the sputtering method, was measured. For example, FIGS. 29 to 32 each show one example of results of measuring light absorption spectrums of samples obtained by replacement of Ga in GaN by a variety of 3d-transition metals. FIG. 29 is a light absorption spectrum of a sample where the 3d-transition metal is V and x = 0.056, having an absorption tail on a longer wavelength side than 3.3 eV, and a broad absorption peak in the vicinity of 1.5 eV. An absorption coefficient in a wavelength of 300 to 1500 nm is 3000 cm⁻¹.

FIG. 30 is a light absorption spectrum of a sample where the 3d-transition metal is Cr and x = 0.088, having an absorption tail on a longer wavelength side than 3.3 eV, and a broad absorption peak in the vicinity of 1.5 to 2.0 eV. An absorption coefficient in a wavelength of 300 to 1500 nm is 1000 cm⁻¹ or more.

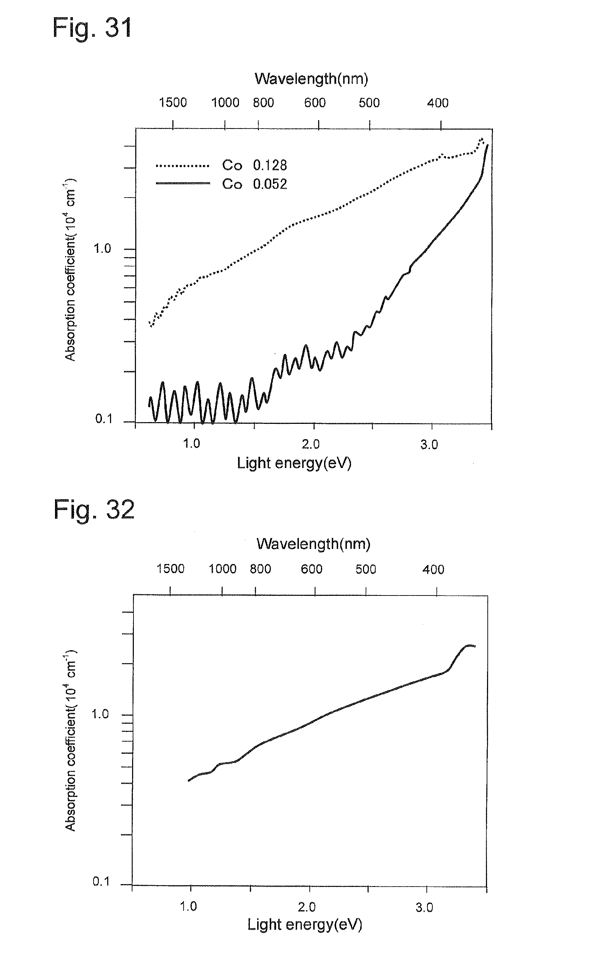

FIG. 31 is a light absorption spectrum of a sample where the 3d-transition metal is Co and x = 0.052, having an absorption tail on a longer wavelength side than 3.3 eV, and an absorption coefficient of 1000 cm⁻¹ in a wavelength of 300 to 1500 nm. Further, a sample where x = 0.128 has an absorption coefficient tail with a peak being in the vicinity of 1.7eV, and an absorption coefficient of 3000 cm⁻¹ in a wavelength of 300 to 1500 nm.

FIG. 32 is a light absorption spectrum of a sample where the 3d-transition metal is Mn and x = 0.2, having a high absorption tail on a longer wavelength side than 3.3 eV, and an absorption coefficient of 5000 cm⁻¹ or more in a wavelength of 300 to 1500 nm. As shown in FIG. 28, the sample produced by the MBE method had a clear absorption peak in the vicinity of 1.5 eV, whereas the sample produced by the sputtering method had a high absorption coefficient, but its clear peak was not observed. What caused this has not been clarified, but it is assumed as follows. The sample produced by the MBE method has relatively high crystalline properties, whereas the sample produced by the sputtering method has low crystalline properties, and it formed a plurality of energy levels in the band gap instead of forming a clear impurity band. The cause is currently under study.

### <Example 8> (Film formation by sputtering method)

A Ga₁₋ₓCrₓN layer (where x = 0.04, 0.08, 0.16) was formed on a p-GaN layer by the sputtering method. For the sputtering method, similar conditions to those in FIG. 7 were used.

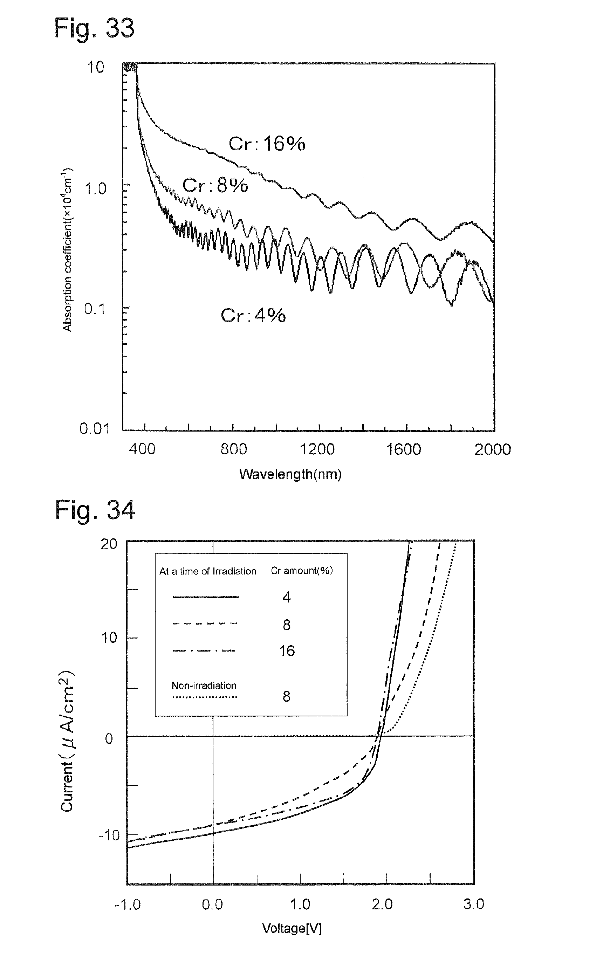

FIG. 33 is a graph showing a light absorption spectrum of the sample. That is, it is a light absorption spectrum of the portion not formed with the extraction electrode A33 and the extraction electrode B34 in the structure shown in FIG. 10. Since the p-GaN layer does not absorb light in the visible region, light is absorbed in this sample by means of the Ga₁₋ₓCrₓN layer. The absorption coefficients in a wavelength of 300 to 1500 nm are all 1000 cm⁻¹ or more, and light absorption increases with increase in Cr content.

### <Example 9> (Production of photoelectric conversion element)

In the pn structure shown in FIG. 10, a photoelectric conversion element was produced using the Ga₁₋ₓCrₓN layer (where x = 0.04, 0.08, 0.16) formed by the sputtering method as the light-absorbing layer, in place of the GaMnN layer 31 as the light-absorbing layer on the p-GaN layer 32.

FIG. 34 is a graph showing voltage-current characteristics at the time of irradiation and non-irradiation of the produced photoelectric conversion element with optical energy of AM-1.5. The characteristic at the time of no-irradiation in the case of x = 0.08 is shown for the sake of brevity, it is not significantly different from ones with x = 0.04 and 0.16. When x was from 0.04 to 0.16, an open-end voltage at the time of irradiation with light was 1.9 to 2.0 V and a short-circuit current was 9 to 10 µA/cm².

### <Example 10> (Production of photoelectric conversion element)

In the pan structure shown in FIG. 2, namely, a photoelectric conversion element was produced by forming a Ga_{0.92}Cr_{0.08}N layer by the sputtering method in place of the GaMnN layer 12 as the light-absorbing layer on the p-GaN layer 13, and then forming the n-GaN layer 11.

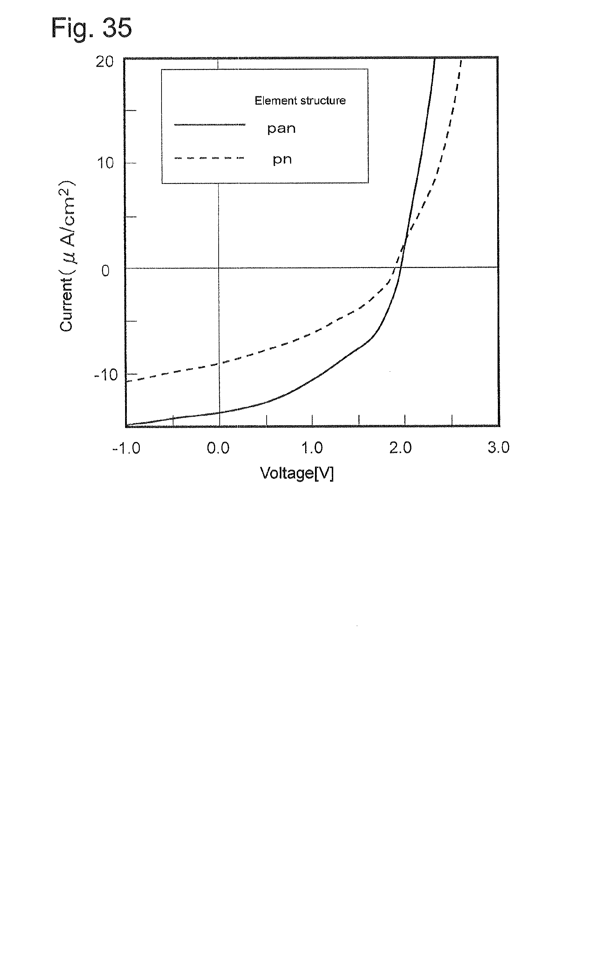

FIG. 35 is a graph showing a voltage-current characteristic at the time of irradiating the produced photoelectric conversion element with light. Therealong, the voltage-current characteristic of the photoelectric conversion element with the pn structure shown in FIG. 34 was also shown for the sake of comparison. For the light-absorbing layer, Ga_{0.92}Cr_{0.08}N as the same material was used. The solar cell having the pan structure shown in FIG. 2 obtained a large short-circuit current as compared with the photoelectric conversion element having the pn structure shown in FIG. 10.

### Industrial Applicability

Since the light-absorbing material of the present invention can absorb sunlight in a broad wavelength region, it is applicable to a photoelectric conversion element such as a solar cell, heat utilization of sunlight, and a light-absorbing element such as an optical filter for absorbing light in a broad range of the wavelength region.

## Claims

1. A light-absorbing material comprising a nitride-based compound semiconductor obtained by replacement of part of Al and/or Ga in a compound semiconductor expressed by a general formula Al_{1-y}Ga_{y}N (0≤y≤1) by at least one kind of 3d-transition metals, the nitride-based compound semiconductor having one or more impurity bands between a valence band and a conduction band, and whose light absorption coefficient over an overall wavelength region of not longer than 1500 nm and not shorter than 300 being not lower than 1000 cm⁻¹.

2. The light-absorbing material according to claim 1, wherein the 3d-transition metal is at least one metal selected from the group consisting of Sc, Ti, V, Cr, Mn, Fe, Co, Ni and Cu.

3. The light-absorbing material according to claim 1, wherein, in case that Ga replacement amount with respect to Al above is y and a replacement amount of a 3d-transition metal T is x, the nitride-based compound semiconductor is expressed by a general formula (Al_{1-y}Ga_{y})₁₋ₓTₓN, and a range of y is 0≤y≤1.0 and a range of x is 0.02≤x≤0.3.

4. The light-absorbing material according to claim 1, wherein the nitride-based compound semiconductor is doped with an acceptor dopant and/or a donor dopant.

5. The light-absorbing material according to claim 1, wherein y in the general formula is 0≤y<1.

6. A photoelectric conversion element comprising a photoelectric conversion layer comprising at least one pn-junction or pan-junction formed by a plurality of compound semiconductor layers, wherein at least one layer of the plurality of compound semiconductor layers is a nitride-based compound semiconductor layer, the nitride-based compound semiconductor layer being made up of a GaN-based, GaAlN-based or AlN-based compound semiconductor obtained by replacement of Ga and/or Al by at least one kind of 3d-transition metals and having at least one or more impurity bands between a valence band and a conduction band, and whose light absorption coefficient over an overall wavelength region of not longer than 1500 nm and not shorter than 300 being not lower than 1000 cm⁻¹.

7. The photoelectric conversion element according to claim 6, wherein the 3d-transition metal is at least one metal selected from the group consisting of Sc, Ti, V, Cr, Mn, Fe, Co, Ni and Cu.

8. The photoelectric conversion element according to claim 6, wherein the nitride-based compound semiconductor layer is doped with an acceptor dopant and/or a donor dopant.

9. The photoelectric conversion element according to claim 8, wherein the acceptor dopant is at least one selected from the group consisting of Mg, Ca and C, and the donor dopant is at least one selected from the group consisting of hydrogen atoms, Si and oxygen atoms.

10. The photoelectric conversion element according to claim 6, wherein the nitride-based compound semiconductor layer has a pair of opposed principal surfaces, and wherein the photoelectric conversion element comprises: an n-type conductive nitride-based compound semiconductor layer, which is formed in contact with one principal surface of the nitride-based compound semiconductor layer, and made up of an n-GaN-based, n-GaAIN-based or n-AIN-based compound semiconductor having n-type conductivity; a p-type conductive nitride-based compound semiconductor layer, which is formed in contact with the other principal surface of the nitride-based compound semiconductor layer, and made up of a p-GaN-based, p-GaAlN-based or p-AlN-based compound semiconductor having p-type conductivity; and at least one pair of electrodes formed respectively on the n-type conductive nitride-based compound semiconductor layer and the p-type conductive nitride-based compound semiconductor layer.

11. The photoelectric conversion element according to claim 6, wherein the photoelectric conversion element comprises: a substrate; an n-type conductive nitride-based compound semiconductor layer, which is formed on the substrate, and made up of an n-GaN-based, n-GaAlN-based or n-AlN-based compound semiconductor having n-type conductivity; the nitride-based compound semiconductor layer formed on the n-type conductive nitride-based compound semiconductor layer; a p-type conductive nitride-based compound semiconductor layer, which is formed in contact with the nitride-based compound semiconductor layer, and made up of a p-GaN-based, p-GaAlN-based or p-AIN-based compound semiconductor having p-type conductivity; and at least one pair of electrodes formed respectively on the n-type conductive nitride-based compound semiconductor layer and the p-type conductive nitride-based compound semiconductor layer.

12. The photoelectric conversion element according to claim 6, wherein the photoelectric conversion element comprises: a substrate; a p-type conductive nitride-based compound semiconductor layer, which is formed on the substrate, and made up of a p-GaN-based, p-GaAlN-based or p-AlN-based compound semiconductor having p-type conductivity; the nitride-based compound semiconductor layer formed on the p-type conductive nitride-based compound semiconductor layer; an n-type conductive nitride-based compound semiconductor layer, which is formed in contact with the nitride-based compound semiconductor layer, and made up of an n-GaN-based, n-GaAlN-based or n-AlN-based compound semiconductor having n-type conductivity; and at least one pair of electrodes formed respectively on the p-type conductive nitride-based compound semiconductor layer and the n-type conductive nitride-based compound semiconductor layer.

13. The photoelectric conversion element according to claim 6, wherein the photoelectric conversion element comprises: the nitride-based compound semiconductor layer; an n-type conductive nitride-based compound semiconductor layer, which is formed in contact with the nitride-based compound semiconductor layer, and made up of an n-GaN-based, n-GaAlN-based or n-AIN-based compound semiconductor having n-type conductivity; and at least one pair of electrodes formed respectively on the nitride-based compound semiconductor layer and the n-type conductive nitride-based compound semiconductor layer.

14. The photoelectric conversion element according to claim 6, wherein the photoelectric conversion element comprises: a substrate; an n-type conductive nitride-based compound semiconductor layer, which is formed on the substrate, and made up of an n-GaN-based, n-GaAlN-based or n-AlN-based compound semiconductor having n-type conductivity; the nitride-based compound semiconductor layer formed on the n-type conductive nitride-based compound semiconductor layer; and at least one pair of electrodes formed respectively on the n-type conductive nitride-based compound semiconductor layer and the nitride-based compound semiconductor layer.

15. The photoelectric conversion element according to claim 6, wherein the photoelectric conversion element comprises: a substrate; the nitride-based compound semiconductor layer formed on the substrate; an n-type conductive nitride-based compound semiconductor layer, which is formed in contact with the nitride-based compound semiconductor layer, and made up of an n-GaN-based, n-GaAlN-based or n-AIN-based compound semiconductor having n-type conductivity; and at least one pair of electrodes formed respectively on the nitride-based compound semiconductor layer and the n-type conductive nitride-based compound semiconductor layer.

16. The photoelectric conversion element according to claim 6, wherein the photoelectric conversion element comprises: the nitride-based compound semiconductor layer; a p-type conductive nitride-based compound semiconductor layer, which is formed in contact with the nitride-based compound semiconductor layer, and made up of a p-GaN-based, p-GaAlN-based or p-AIN-based compound semiconductor having p-type conductivity; and at least one pair of electrodes formed respectively on the nitride-based compound semiconductor layer and the p-type conductive nitride-based compound semiconductor layer.

17. The photoelectric conversion element according to claim 6, wherein the photoelectric conversion element comprises: a substrate; a p-type conductive nitride-based compound semiconductor layer, which is formed on the substrate, and made up of a p-GaN-based, p-GaAIN-based or p-AlN-based compound semiconductor having p-type conductivity; the nitride-based compound semiconductor layer formed on the p-type conductive nitride-based compound semiconductor layer; and at least one pair of electrodes formed respectively on the nitride-based compound semiconductor layer and the p-type conductive nitride-based compound semiconductor layer.

18. The photoelectric conversion element according to claim 6, wherein the photoelectric conversion element comprises: a substrate; the nitride-based compound semiconductor layer formed on the substrate; a p-type conductive nitride-based compound semiconductor layer, which is formed in contact with the nitride-based compound semiconductor layer, and made up of a p-GaN-based, p-GaAIN-based or p-AIN-based compound semiconductor having p-type conductivity; and at least one pair of electrodes formed respectively on the nitride-based compound semiconductor layer and the p-type conductive nitride-based compound semiconductor layer.
